# EUROPEAN PATENT APPLICATION

(11) **EP 3 425 004 A1**
(43) Date of publication of application: **09.01.2019**
(21) Application number: 17760051.7
(22) Date of filing: 28.02.2017
(51) Int. Cl.: C08L 59/00, C08K 3/00, C08K 7/14, C09K 5/14

(54) **COMPOSITION FOR LOW THERMAL EXPANSION MEMBERS, LOW THERMAL EXPANSION MEMBER, ELECTRONIC DEVICE, AND METHOD FOR PRODUCING LOW THERMAL EXPANSION MEMBER**

(30) Priority: 02.03.2016 JP 2016040523
(71) Applicant: JNC Corporation, Chiyoda-ku Tokyo 100-8105 (JP); Osaka Research Institute of Industrial Science and Technology, Izumi-shi, Osaka 594-1157 (JP)
(72) Inventor: FUJIWARA,Takeshi, Ichihara-shi Chiba 290-8551 (JP); INAGAKI, Jyunichi, Ichihara-shi Chiba 290-8551 (JP); AGARI, Yasuyuki, Osaka-shi Osaka 536-8553 (JP); HIRANO, Hiroshi, Osaka-shi Osaka 536-8553 (JP); KADOTA, Joji, Osaka-shi Osaka 536-8553 (JP); OKADA, Akinori, Osaka-shi Osaka 536-8553 (JP)
(74) Representative: Becker Kurig Straus
(86) International application number: PCT/JP2017/008027
(87) International publication number: WO 2017/150587

(57) **Abstract**

The present invention provides: a composition for low thermal expansion members, which is capable of forming a low thermal expansion member that has a thermal expansion coefficient close to those of the members within a semiconductor element, while having high heat resistance and high heat conductivity; and a low thermal expansion member. A composition for low thermal expansion members according to the present invention is characterized by containing: a heat conductive first inorganic filler 1 that is bonded to one end of a first coupling agent 11; and a heat conductive second inorganic filler 2 that is bonded to one end of a second coupling agent 12. This composition for low thermal expansion members is also characterized in that the first inorganic filler 1 and the second inorganic filler 2 are bonded to each other via the first coupling agent 11 and the second coupling agent 12 by means of a curing treatment.

## Description

### [Technical Field]

The present invention relates to a composition for a low thermal expansion member used for an electronic instrument such as an electronic substrate, and particularly, to a composition for a low thermal expansion member that can form an electronic instrument member which has both processability of a resin and a high heat resistance of 250 °C or higher, and additionally, efficiently transfer and conduct heat generated in an electronic instrument and thus can dissipate heat.

### [Background Art]

In recent years, in semiconductor devices for power control of electric trains, hybrid vehicles, and electric vehicles, operation temperatures thereof have risen due to use of wide gap semiconductors. In silicon carbide (SiC) semiconductors and the like which have been particularly focused upon, since the operation temperature is 200 °C or higher, a packaging material therefor needs to have a high heat resistance of 250 °C or higher. In addition, due to the rise in the operation temperature, thermal distortion may occur due to a difference between thermal expansion coefficients of materials used in a package, and there is also a problem of a reduced lifespan due to peeling of a wiring or the like.

As a method of solving such a heat resistance problem, it is important to increase heat resistance of a resin, and particularly the development of high heat resistance resins such as oxazine resins and high heat resistance silicone resins have progressed. In Patent Literature 1, a polybenzoxazine-modified bismaleimide resin having excellent heat resistance is disclosed. However, compounds that exhibit sufficient heat resistance and durability have not yet been utilized, and thus the development of materials with higher heat resistance has been performed.

As another method of solving a heat resistance problem of a member, there is a method in which thermal conductivity is improved, unevenness in temperature is reduced, and as a result, localized high temperatures are reduced. For example, highly thermally conductive ceramic substrates such as aluminum nitride and silicon nitride and highly heat resistant organic resins and silicone resins combined with inorganic fillers for improving thermal conductivity have been developed. Generally, the introduction of many cyclic structures into a main chain of molecules in order to increase thermal conductivity of a resin component has been examined. In addition, it is known that high linearity of molecular chains is preferred in order to improve thermal conductivity of such resins. Examples of a compound having many cyclic structures and linearity include a liquid crystal compound.

In Patent Literature 2, as a method of improving the thermal conductivity of a resin, a method in which a liquid crystal composition containing a liquid crystal compound having a polymerization group at both ends is alignment-controlled using an alignment control additive, a rubbing treatment method, or the like, polymerization is performed in a state in which the alignment state is maintained, and thus a resin film having high thermal conductivity is obtained is disclosed.

In addition, as a method of solving a problem of a reduced lifespan due to thermal distortion, research has been conducted to improve a molecular structure of an epoxy resin and reduce a thermal expansion coefficient of a resin itself and the development of a device structure that alleviates stress due to thermal distortion has been performed (Patent Literature 3 to 5).

### [Citation List]

### [Patent Literature]

[Patent Literature 1]
   Japanese Unexamined Patent Application Publication No. 2012-97207
[Patent Literature 2]
   Japanese Unexamined Patent Application Publication No. 2006-265527
[Patent Literature 3]
   Japanese Unexamined Patent Application Publication No. 2016-26261
[Patent Literature 4]
   Japanese Unexamined Patent Application Publication No. 2016-004796
[Patent Literature 5]
   Japanese Unexamined Patent Application Publication No. 2015-90884

### [Summary of Invention]

### [Technical Problem]

As described above, for a substrate of a semiconductor device used at high temperatures, a material having high heat resistance and thermal conductivity is desirable. In addition, a thick copper electrode is laminated on a substrate in order for high power flow to a semiconductor, but large stress is applied to an adhesive surface due to a difference between thermal expansion coefficients of the substrate and copper, and there is also a problem of the electrode peeling off. However, if the thermal expansion coefficients of the substrate and the copper electrode are almost the same, it is possible to prevent the problem of peeling off.

Thus, an objective of the present invention is to provide a composition for a low thermal expansion member that can form a low thermal expansion member of which a thermal expansion coefficient is close to that of a member inside a semiconductor device of such as copper and SiC and which has high heat resistance and also has high thermal conductivity, and a low thermal expansion member suitable for a semiconductor device substrate and the like.

### [Solution to Problem]

The inventors found that, in combining an organic material and an inorganic material, when inorganic materials are connected to each other rather than adding an inorganic material to a resin, that is, when inorganic materials are directly bonded to each other using a silane coupling agent bonded to surfaces of the inorganic materials and a bifunctional or higher polymerizable compound (refer to FIG. 2), or when inorganic materials are directly bonded to each other using a coupling agent (refer to FIGs. 3 and 4), it is possible to possible to realize a composite material which has very high heat resistance (a glass transition temperature and a decomposition temperature) of 250 °C or higher, high thermal conductivity, and a thermal expansion coefficient that is almost the same as that of copper, and completed the present invention.

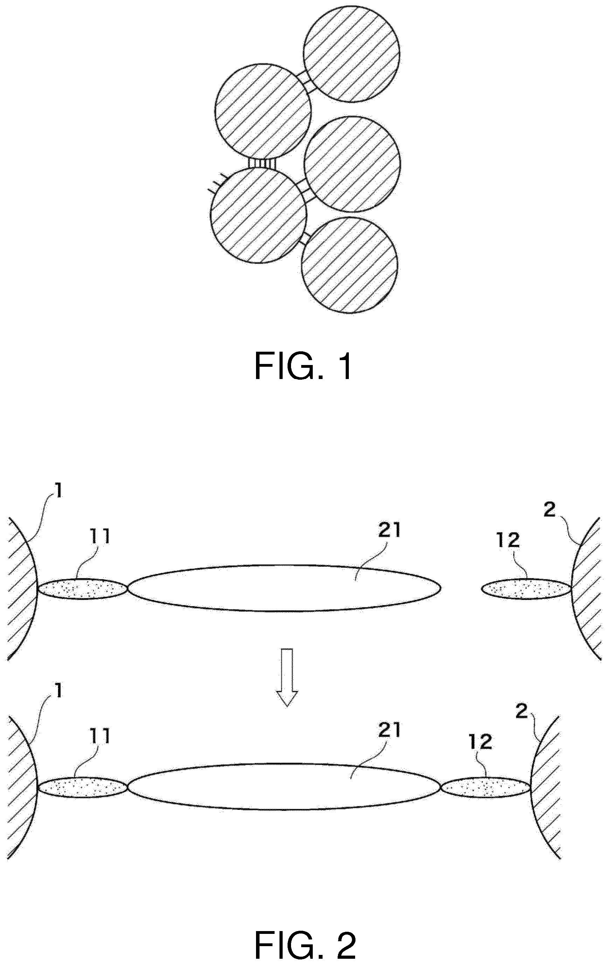

For example, as shown in FIG. 2, a composition for a low thermal expansion member according to a first aspect of the present invention includes a thermally conductive first inorganic filler 1 bonded to one end of a first coupling agent 11 and a thermally conductive second inorganic filler 2 bonded to one end of a second coupling agent 12, and through curing treatment, the first inorganic filler 1 and the second inorganic filler 2 are bonded to each other via the first coupling agent 11 and the second coupling agent 12.

"One end" and "the other end" described later may be tips or ends in a shape of a molecule and may or may not be both ends of the long side of a molecule. "Via" means inclusion in a bond between inorganic fillers. A bond between inorganic fillers may be formed by directly bonding coupling agents to each other or may be formed by bonding coupling agents to each other using another compound. The "curing treatment" is typically heating or light radiation. The composition of the present invention has a characteristic that, when it is heated or irradiated with light, a bond is formed between inorganic fillers.

In such a configuration, it is possible to form a low thermal expansion member by bonding the inorganic fillers via the coupling agent. Since the inorganic fillers are directly bonded, it possible to form a composite member in which a glass transition as in a polymer is not exhibited, thermal decomposition is unlikely to occur, and heat can be directly transferred by phonon oscillation through the coupling agent.

In a composition for a low thermal expansion member according to a second aspect of the present invention, the first inorganic filler and the second inorganic filler are at least one selected from the group consisting of alumina, zirconia, magnesium oxide, zinc oxide, silica, cordierite, silicon nitride, and silicon carbide, in the composition for a low thermal expansion member according to the first aspect of the present invention

In such a configuration, the thermal conductivity of the inorganic fillers is high and when combining them, a desired composition for a low thermal expansion member is obtained.

In a composition for a low thermal expansion member according to a third aspect of the present invention, the first coupling agent and the second coupling agent are the same, in the composition for a low thermal expansion member according to the first aspect or second aspect of the present invention.

In such a configuration, since a procedure of separately preparing two types of fillers and uniformly mixing them is not necessary, the productivity is improved.

A composition for a low thermal expansion member according to a fourth aspect of the present invention further includes a thermally conductive third inorganic filler having a different thermal expansion coefficient from those of the first inorganic filler and the second inorganic filler in the composition for a low thermal expansion member according to any one of the first to third aspects of the present invention.

In such a configuration, when the first inorganic filler and the second inorganic filler have different thermal expansion coefficients, if these are combined, a thermal expansion coefficient of the combined composition for a low thermal expansion member has a value intermediate between those of formulations with only one of the fillers. However, in this state, there are many gaps within the filler, and not only does the thermal conductivity not increase but also electrical insulating properties deteriorate due to water that has entered the gaps. Therefore, when the third inorganic filler having high thermal conductivity and a smaller particle size than the first and second inorganic fillers is added, there is an advantage of increasing the stability of the material by filling the gap between the first and second inorganic fillers. Thus, compared to a case in which only the first and second inorganic fillers are used, when the third inorganic filler having higher thermal conductivity is added, it is possible to increase thermal conductivity of the cured product. There is no limitation on the inorganic filler used as the third inorganic filler. However, when strong insulation properties are required, boron nitride, aluminum nitride, silicon carbide, and silicon nitride can be preferably used. On the other hand, when strong insulation properties are not required, diamond, carbon nanotubes, graphene, and metal powder having high thermal conductivity can be preferably used. The third inorganic filler may or may not be treated with a silane coupling agent and a bifunctional or higher polymerizable compound.

A composition for a low thermal expansion member according to a fifth aspect of the present invention further includes an organic compound, a polymer compound, or glass fibers that are not bonded to the first inorganic filler or the second inorganic filler, in the composition for a low thermal expansion member according to any one of the first to fourth aspects of the present invention.

In such a configuration, in the composition for a low thermal expansion member, when the particle size of the filler is increased in order to improve thermal conductivity, the porosity increases accordingly. Since voids can be filled with an organic compound, a polymer compound, or a glass fiber that is not bonded to the first inorganic filler or the second inorganic filler, it is possible to improve thermal conductivity and water vapor barrier properties.

In a composition for a low thermal expansion member according to a sixth aspect of the present invention, for example, as shown in FIG. 2, in the composition for a low thermal expansion member, one end of a bifunctional or higher polymerizable compound 21 is bonded to the other end of the first coupling agent 11 and through curing treatment, the other end of the polymerizable compound 21 is bonded to the other end of the second coupling agent 12 in the composition for a low thermal expansion member according to any one of the first to fifth aspects of the present invention.

In such a configuration, it is possible to form a low thermal expansion member by directly bonding the inorganic fillers to each other using the coupling agent and the bifunctional or higher polymerizable compound.

In a composition for a low thermal expansion member according to a seventh aspect of the present invention, the bifunctional or higher polymerizable compound is at least one polymerizable liquid crystal compound represented by the following Formula (1-1), in the composition for a low thermal expansion member according to the sixth aspect of the present invention:

R^{a}-Z-(A-Z)ₘ-R^{a} (1-1)

[in the above Formula (1-1),
R^{a} independently represents a functional group that can be bonded to a functional group of the other end of a first coupling agent and a second coupling agent;
A is 1,4-cyclohexylene, 1,4-cyclohexenylene, 1,4-phenylene, naphthalene-2,6-diyl, tetrahydronaphthalene-2,6-diyl, fluorene-2,7-diyl, bicyclo[2.2.2]oct-1,4-diyl, or bicyclo[3.1.0]hex-3,6-diyl,
in these rings, any -CH₂- is optionally substituted with -O-, any -CH= is optionally substituted with -N=, and any hydrogen atom is optionally substituted with a halogen atom, an alkyl group having 1 to 10 carbon atoms, or an alkyl halide having 1 to 10 carbon atoms,
in the alkyl group, any -CH₂- is optionally substituted with -O-, -CO-, -COO-, -OCO-, -CH=CH-, or -C≡C-;
Z independently represents a single bond or an alkylene group having 1 to 20 carbon atoms,
in the alkylene group, any -CH₂- is optionally substituted with -O-, -S-, -CO-, -COO-, -OCO-, -CH=CH-, -CF=CF-, -CH=N-, -N=CH-, -N=N-, -N(O)=N-, or -C≡C-, and any hydrogen atom is optionally substituted with a halogen atom;
m is an integer of 1 to 6]

In such a configuration, since the inorganic fillers are directly bonded to each other using molecules of the coupling agent and the liquid crystal compound having high heat resistance, it is possible to form a composite member in which a glass transition as in a polymer is not exhibited, thermal decomposition is unlikely to occur, and heat can be directly transferred by phonon oscillation through molecules of the coupling agent and the liquid crystal compound.

In a composition for a low thermal expansion member according to an eighth aspect of the present invention, in Formula (1-1), A is 1,4-cyclohexylene, 1,4-cyclohexylene in which any hydrogen atom is substituted with a halogen atom, 1,4-phenylene, 1,4-phenylene in which any hydrogen atom is substituted with a halogen atom or a methyl group, fluorene-2,7-diyl, or fluorene-2,7-diyl in which any hydrogen atom is substituted with a halogen atom or a methyl group, in the composition for a low thermal expansion member according to the seventh aspect of the present invention.

In such a configuration, the composition for a low thermal expansion member can contain a more preferable compound as a polymerizable liquid crystal compound. These compounds are thought to have higher molecular linearity and more advantageous phonon conduction.

In a composition for a low thermal expansion member according to a ninth aspect of the present invention, in Formula (1-1), Z is a single bond, -(CH₂)ₐ-, -O(CH₂)ₐ-, -(CH₂)ₐO-, -O(CH₂)ₐO-, -CH=CH-, -C≡C-, -COO-, -OCO-, -CH=CH-COO-, -OCO-CH=CH-, -CH₂CH₂-COO-, -OCO-CH₂CH₂-, -CH=N-, -N=CH-, -N=N-, -OCF₂- or -CF₂O-, and a is an integer of 1 to 20, in the composition for a low thermal expansion member according to the seventh aspect or the eighth aspect of the present invention.

In such a configuration, the composition for a low thermal expansion member can contain a particularly preferable compound as a polymerizable liquid crystal compound. These compounds are preferable because they have excellent physical properties, ease of production, and ease of handling.

In a composition for a low thermal expansion member according to a tenth aspect of the present invention, in Formula (1-1), R^{a} each represents polymerizable groups having the following Formulae (2-1) and (2-2), cyclohexene oxide, phthalic anhydride, or succinic anhydride, in the composition for a low thermal expansion member according to any one of the seventh to ninth aspects of the present invention. 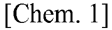 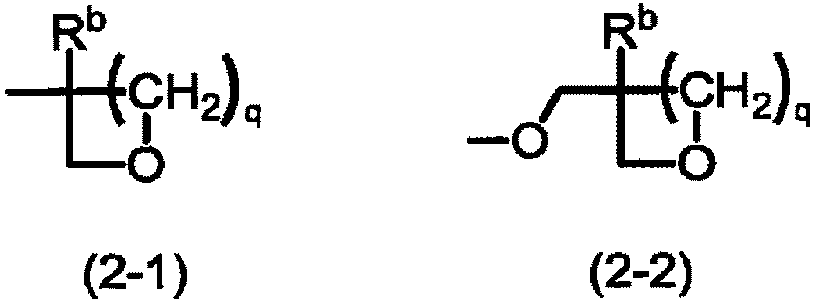 [in Formulae (2-1) and (2-2), R^{b} is a hydrogen atom, a halogen atom, -CF₃, or an alkyl group having 1 to 5 carbon atoms, and q is 0 or 1]

In such a configuration, the polymerizable liquid crystal compound is thermosetting, and can be cured without being affected by an amount of the filler, and also has excellent heat resistance. In addition, since the molecular structure has symmetry and linearity, these properties are advantageous for conduction of phonons.

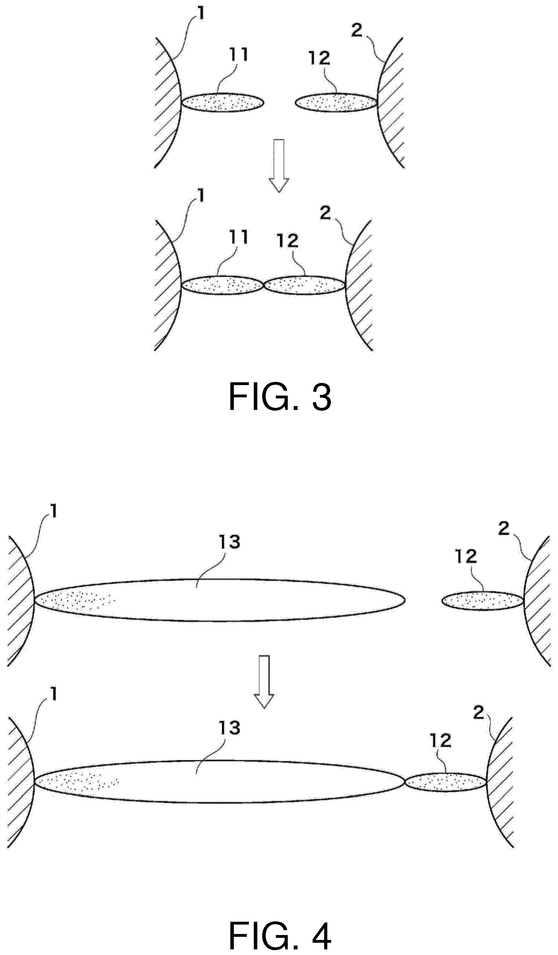

In a composition for a low thermal expansion member according to an eleventh aspect of the present invention, for example, as shown in FIG. 3, the first coupling agent 11 and the second coupling agent 12 each have a functional group that can be bonded to each other at the other end thereof, and through curing treatment, the other end of the first coupling agent 11 is bonded to the other end of the second coupling agent 12, in the composition for a low thermal expansion member according to any one of the first to fifth aspects of the present invention.

In such a configuration, it is possible to form a low thermal expansion member by directly bonding the inorganic fillers to each other using the coupling agent.

In a composition for a low thermal expansion member according to a twelfth aspect of the present invention, the first inorganic filler and the second inorganic filler have a spherical shape, in the composition for a low thermal expansion member according to any one of the first to eleventh aspects of the present invention.

The "spherical shape" is not limited to a perfect spherical shape and it may be a rugby ball shape, and indicates a shape in which a value obtained by dividing a particle size in a direction perpendicular to a maximum particle size (maximum diameter) of a filler by the maximum diameter is 0.5 or more.

In such a configuration, it is possible to improve 3-dimensional uniformity of the thermal conductivity of the low thermal expansion member.

A low thermal expansion member according to a thirteenth aspect of the present invention is a low thermal expansion member obtained by curing the composition for a low thermal expansion member according to any one of the first to twelfth aspects of the present invention.

In such a configuration, the low thermal expansion member has a bond between the inorganic fillers, and since this bond does not cause molecular vibration or phase change like in a general resin, the low thermal expansion member can have a high linearity of thermal expansion and higher thermal conductivity.

An electronic instrument according to a fourteenth aspect of the present invention includes the low thermal expansion member according to the thirteenth aspect of the present invention and an electronic device including a heating unit, and the low thermal expansion member is disposed on the electronic device such that it comes in contact with the heating unit.

In such a configuration, since the low thermal expansion member has favorable heat resistance and a thermal expansion coefficient that can be controlled at high temperatures, it is possible to reduce thermal distortion that may occur in an electronic instrument.

A method of producing a low thermal expansion member according to a fifteenth aspect of the present invention includes a process of bonding a thermally conductive and spherical first inorganic filler to one end of a first coupling agent; a process of bonding a thermally conductive and spherical second inorganic filler to one end of a second coupling agent; and a process of bonding the other end of the first coupling agent to one end of a bifunctional or higher polymerizable compound and bonding the other end of the polymerizable compound to the other end of the second coupling agent or a process of bonding the other end of the first coupling agent to the other end of the second coupling agent.

In such a configuration, a method of producing a low thermal expansion member in which inorganic fillers are directly bonded to each other using a coupling agent and a bifunctional or higher polymerizable compound or a low thermal expansion member in which inorganic fillers are directly bonded to each other using a coupling agent is provided.

### [Advantageous Effects of Invention]

A low thermal expansion member formed from the composition for a low thermal expansion member of the present invention has very high heat resistance, stable thermal expansion properties, and high thermal conductivity as an organic-inorganic composite material. In addition, the low thermal expansion member has excellent properties such as chemical stability, heat resistance, hardness and mechanical strength. The composition for a low thermal expansion member can be used, for example, an electronic substrate cured in a sheet form, and is suitable as a composition for an adhesive, a filler, a sealant, and a heat-resistant insulating coating. In addition, the member may be molded into a three-dimensional structure using a mold or the like, and used for a component in which thermal expansion of a precision instrument is a problem.

### [Brief Description of Drawings]

FIG. 1 is a plan view showing bonding of inorganic fillers using spherical alumina as an example in a low thermal expansion member of the present invention.
FIG. 2 is a conceptual diagram showing a state in which, through curing treatment of a composition for a low thermal expansion member, the other end of a polymerizable compound 21 bonded to a first coupling agent 11 is bonded to the other end of a second coupling agent 12.
FIG. 3 is a conceptual diagram showing a state in which, through curing treatment of a composition for a low thermal expansion member, the other end of the first coupling agent 11 is bonded to the other end of the second coupling agent 12.
FIG. 4 is a conceptual diagram showing a state in which, through curing treatment of a composition for a low thermal expansion member, the other end of the first coupling agent 13 is bonded to the other end of the second coupling agent 12.

### [Description of Embodiments]

Priority is claimed on Japanese Patent Application No. 2016-040523, filed March 2, 2016, the content of which is incorporated herein by reference. The present invention will be more completely understood from the following detailed description. Further scope for application of the present invention will be clearly understood from the following detailed description. It should be understood, however, that the detailed description and the specific examples are preferred embodiments of the present invention and are set forth for the purpose of illustration only. From the detailed description, various modifications and alternations within the spirit and scope of the present invention will be clearly understood by those skilled in the art. The applicants do not intend to present any of described embodiments to the public and among alternations and alternative proposals, those that are not explicitly included in the scope of claims are parts of the invention under the doctrine of equivalents.

Embodiments of the present invention will be described below with reference to the drawings. Here, in the drawings, the same or corresponding parts will be denoted with the same or similar reference numerals, and redundant descriptions will be omitted. In addition, the present invention is not limited to the following embodiments.

The terms used in this specification are as follows.

A "liquid crystal compound" or a "liquid crystalline compound" is a compound that exhibits a liquid crystal phase such as a nematic phase or a smectic phase.

When it is stated that "any -CH₂- in an alkyl group is optionally substituted with -O-" or "any -CH₂CH₂- is optionally substituted with -CH=CH-," this means the following for example. For example, examples of groups in which any -CH₂- in C₄H₉- is substituted with -O- or -CH=CH- include C₃H₇O-, CH₃-O-(CH₂)₂-, and CH₃-O-CH₂-O-. Similarly, examples of groups in which any -CH₂CH₂- in C₅H₁₁- is substituted with -CH=CH- include H₂C=CH-(CH₂)₃-, and CH₃-CH=CH-(CH₂)₂-, and examples of groups in which any -CH₂- is substituted with -O- include CH₃-CH=CH-CH₂-O-. Thus, the term "any" means "at least one selected without distinction." Here, in consideration of stability of a compound, CH₃-O-CH₂-O- in which oxygen and oxygen are not adjacent to each other is preferable to CH₃-O-O-CH₂- in which oxygen and oxygen are adjacent to each other.

In addition, regarding a ring A, when it is stated that "any hydrogen atom is optionally substituted with a halogen, an alkyl group having 1 to 10 carbon atoms, or an alkyl halide having 1 to 10 carbon atoms," this means a case in which, for example, at least one of hydrogen atoms at the 2, 3, 5, and 6 positions on 1,4-phenylene is substituted with a substituent such as a fluorine atom or a methyl atom and a case in which a substituent is "an alkyl halide having 1 to 10 carbon atoms" includes examples such as 2-fluoroethyl and 3-fluoro-5-chlorohexyl.

"Compound (1-1)" means a bifunctional or higher polymerizable liquid crystal compound represented by the following Formula (1-1) to be described below and may also mean at least one compound represented by the following Formula (1-1). When one Compound (1-1) includes a plurality of A, any two A may be the same as or different from each other. When a plurality of Compounds (1-1) include A, any two A may be the same as or different from each other. This rule also applies to other symbols and groups such as R^{a} and Z.

### [Composition for a low thermal expansion member]

The composition for a low thermal expansion member is a composition that can form a low thermal expansion member by directly bonding inorganic fillers using a coupling agent and a bifunctional or higher polymerizable compound through curing treatment. FIG. 1 shows an example in which a spherical alumina is used as an inorganic filler. When an alumina is treated with a coupling agent, the coupling agent binds to the entire surface. An alumina treated with a coupling agent can form a bond with a bifunctional or higher polymerizable compound. Therefore, when coupling agents bonded to an alumina are connected using a bifunctional or higher polymerizable compound (refer to FIG. 2), alumina molecules are bonded to each other as shown in FIG. 1.

In this manner, when inorganic fillers are bonded to each other using a coupling agent and a bifunctional or higher polymerizable compound, since phonons can be directly propagated, the cured low thermal expansion member has very high thermal conductivity, and it is possible to produce a composite member in which a thermal expansion coefficient of an inorganic component is directly reflected. Here, in this specification, a low thermal expansion means 30×10⁻⁶/°C or less.

For example, as shown in FIG. 2, a composition for a low thermal expansion member according to a first embodiment of the present invention includes a first inorganic filler 1 which is bonded to one end of a first coupling agent 11 and has a small thermal expansion coefficient and high thermal conductivity, and a second inorganic filler 2 which is bonded to one end of a second coupling agent 12 and has a small thermal expansion coefficient and high thermal conductivity. In addition, one end of a polymerizable compound 21 is bonded to the other end of the first coupling agent 11. However, the other end of the polymerizable compound 21 is not bonded to the other end of the second coupling agent 12.

As shown in FIG. 2, when the composition for a low thermal expansion member is cured, the other end of the second coupling agent 12 is bonded to the other end of the polymerizable compound 21. In this manner, a bond between inorganic fillers is formed. Here, realization of such a bond between the inorganic fillers is important in the present invention, and before the silane coupling agent is bonded to the inorganic filler, a silane coupling agent and a bifunctional or higher polymerizable compound may be reacted with each other using an organic synthetic technique in advance.

### <Bifunctional or higher polymerizable compound>

As the bifunctional or higher polymerizable compound bonded to the first coupling agent, a bifunctional or higher polymerizable liquid crystal compound (hereinafter simply referred to as a "polymerizable liquid crystal compound" in some cases) is preferably used.

As the polymerizable liquid crystal compound, a liquid crystal compound represented by the following Formula (1-1) is preferable, which has a liquid crystal framework and a polymerizable group, and has high polymerization reactivity, a wide temperature range of a liquid crystal phase, favorable miscibility, and the like. When Compound (1-1) is mixed with other liquid crystal compounds or polymerizable compounds, the mixture is likely to be uniform.

R^{a}-Z-(A-Z)ₘ-R^{a} (1-1)

When a terminal group R^{a}, a ring structure A and a bond group Z of Compound (1-1) are appropriately selected, it is possible to arbitrarily adjust physical properties such as a liquid crystal phase exhibition range. Effects of types of the terminal group R^{a}, the ring structure A and the bond group Z on physical properties of Compound (1-1) and preferable examples thereof will be described below.

### • Terminal group R^{a}

The terminal group R^{a} may independently represents a functional group that can be bonded to a functional group of the other end of the first coupling agent and the second coupling agent.

For example, polymerizable groups represented by the following Formulae (2-1) and (2-2), cyclohexene oxide, phthalic anhydride, and succinic anhydride can be exemplified, but the present invention is not limited thereto. 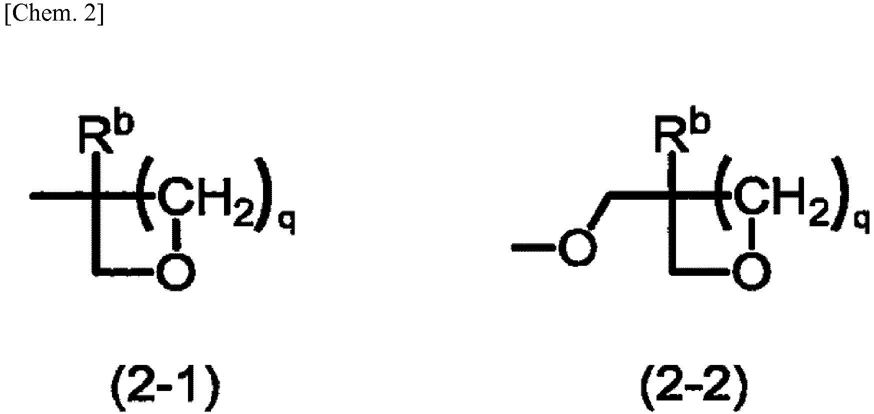 [in Formulae (2-1) and (2-2), R^{b} is a hydrogen atom, a halogen atom, -CF₃, or an alkyl group having 1 to 5 carbon atoms, and q is 0 or 1]

In addition, examples of a combination of functional groups that form a bond between the terminal group R^{a} and the coupling agent include a combination of an oxiranyl group and an amino group, a combination of vinyl groups, a combination of methacryloxy groups, a combination of a carboxy or carboxylic acid anhydride residue and an amine group, and a combination of imidazole and an oxiranyl group, but the present invention is not limited thereto. A combination with high heat resistance is more preferable.

### • Ring structure A

When at least one ring in the ring structure A of Compound (1-1) is 1,4-phenylene, an orientational order parameter and magnetization anisotropy are large. In addition, when at least two rings are 1,4-phenylene, a temperature range of a liquid crystal phase is wide and a clearing point is also high. When at least one hydrogen atom on the 1,4-phenylene ring is substituted with a cyano group, a halogen atom, -CF₃ or -OCF₃, dielectric anisotropy is large. In addition, when at least two rings are 1,4-cyclohexylene, a clearing point is high and the viscosity is small.

Examples of a preferable A include 1,4-cyclohexylene, 1,4-cyclohexenylene, 2,2-difluoro-1,4-cyclohexylene, 1,3-dioxane-2,5-diyl, 1,4-phenylene, 2-fluoro-1,4-phenylene, 2,3-difluoro-1,4-phenylene, 2,5-difluoro-1,4-phenylene, 2,6-difluoro-1,4-phenylene, 2,3,5-trifluoro-1,4-phenylene, pyridine-2,5-diyl, 3-fluoropyridine-2,5-diyl, pyrimidine-2,5-diyl, pyridazine-3,6-diyl, naphthalene-2,6-diyl, tetrahydronaphthalene-2,6-diyl, fluorene-2,7-diyl, 9-methyl fluorene-2,7-diyl, 9,9-dimethyl fluorene-2,7-diyl, 9-ethyl fluorene-2,7-diyl, 9-fluoro fluorene-2,7-diyl, and 9,9-difluoro fluorene-2,7-diyl.

Regarding the configuration of 1,4-cyclohexylene and 1,3-dioxane-2,5-diyl, a trans configuration is preferable to a cis configuration. Since 2-fluoro-1,4-phenylene and 3-fluoro-1,4-phenylene are structurally the same, the latter is not shown. This rule also applies to a relationship between 2,5-difluoro-1,4-phenylene and 3,6-difluoro-1,4-phenylene.

Examples of a more preferable A include 1,4-cyclohexylene, 1,4-cyclohexenylene, 1,3-dioxane-2,5-diyl, 1,4-phenylene, 2-fluoro-1,4-phenylene, 2,3-difluoro-1,4-phenylene, 2,5-difluoro-1,4-phenylene, and 2,6-difluoro-1,4-phenylene. Examples of a particularly preferable A include 1,4-cyclohexylene and 1,4-phenylene.

### • Bond group Z

When the bond group Z of Compound (1-1) is a single bond, -(CH₂)₂-, -CH₂O-, -OCH₂-, -CF₂O-, -OCF₂-, -CH=CH-, -CF=CF- or -(CH₂)₄-, and particularly, is a single bond, -(CH₂)₂-, -CF₂O-, -OCF₂-, -CH=CH- or -(CH₂)₄-, the viscosity is low. In addition, when the bond group Z is -CH=CH-, -CH=N-, -N=CH-, -N=N- or -CF=CF-, a temperature range of a liquid crystal phase is wide. In addition, when the bond group Z is an alkyl group having about 4 to 10 carbon atoms, a melting point is lowered.

Examples of a preferable Z include a single bond, -(CH₂)₂-, -(CF₂)₂-, -COO-, -OCO-, -CH₂O-, -OCH₂-, -CF₂O-, -OCF₂-, -CH=CH-, -CF=CF-, -C≡C-, -(CH₂)₄-, -(CH₂)₃O-, -O(CH₂)₃-, -(CH₂)₂COO-, -OCO(CH₂)₂-, -CH=CH-COO-, and -OCO-CH=CH-.

Examples of a more preferable Z include a single bond, -(CH₂)₂-, -COO-, -OCO-, -CH₂O-, -OCH₂-, -CF₂O-, -OCF₂-, -CH=CH-, and -C≡C-. Examples of a particularly preferable Z include a single bond, -(CH₂)₂-, -COO- and -OCO-.

When Compound (1-1) has 3 or fewer rings, the viscosity is low and when Compound (1-1) has 3 or more rings, a clearing point is high. Here, in this specification, a 6-membered ring, a condensed ring including a 6-membered ring and the like are basically regarded as a ring. For example, a 3-membered ring, a 4-membered ring, or a 5-membered ring alone is not regarded as a ring. In addition, a condensed ring such as a naphthalene ring and a fluorene ring is regarded as one ring.

Compound (1-1) may be optically active or optically inactive. When Compound (1-1) is optically active, Compound (1-1) may have an asymmetric carbon atom or may have axial asymmetry. The configuration of an asymmetric carbon atom may be R or S. The asymmetric carbon atom may be positioned in either R^{a} or A. When the asymmetric carbon atom is included, the compatibility of Compound (1-1) is favorable. When Compound (1-1) has axial asymmetry, a twisting induction force is large. In addition, light fixation is inconsequential in any case.

As described above, when types of the terminal group R^{a}, the ring structure A and the bond group Z, and the number of rings are appropriately selected, it is possible to obtain a compound having desired physical properties.

### • Compound (1-1)

Compound (1-1) can also be represented by the following Formula (1-a) or (1-b).

P-Y-(A-Z)ₘ-R^{a} (1-a)

P-Y-(A-Z)ₘ-Y-P (1-b)

In the above Formulae (1-a) and (1-b), A, Z, and R^{a} have the same definitions as A, Z, and R^{a} defined in the above Formula (1-1). P indicates polymerizable groups represented by the following Formulae (2-1) and (2-2), cyclohexene oxide, phthalic anhydride, or succinic anhydride, and Y is a single bond or an alkylene group having 1 to 20 carbon atoms, and preferably an alkylene group having 1 to 10 carbon atoms, and in the alkylene group, any -CH₂- is optionally substituted with -O-, -S-, -CO-, -COO-, -OCO- or -CH=CH-. A particularly preferable Y is an alkylene group in which -CH₂- at one end or both ends of an alkylene group having 1 to 10 carbon atoms is substituted with -O-. m is an integer of 1 to 6, preferably an integer of 2 to 6, and more preferably an integer of 2 to 4. 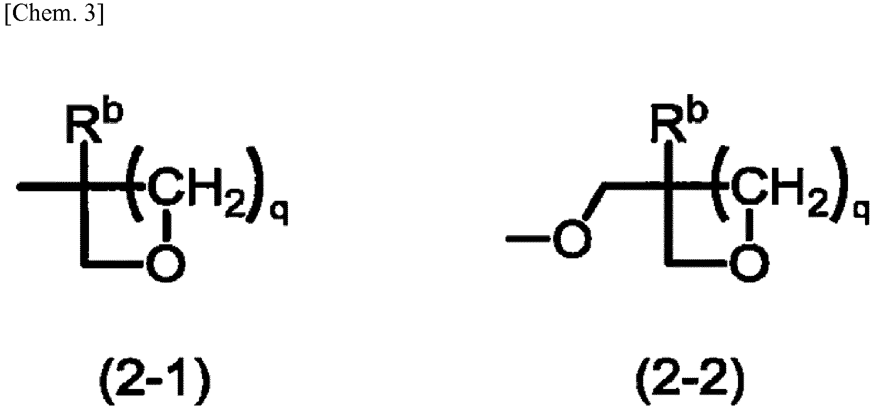 [in Formulae (2-1) and (2-2), R^{b} is a hydrogen atom, a halogen atom, -CF₃, or an alkyl group having 1 to 5 carbon atoms, and q is 0 or 1]

Preferable examples of Compound (1-1) include the following Compounds (a-1) to (a-10), (b-1) to (b-16), (c-1) to (c-16), (d-1) to (d-15), (e-1) to (e-15), (f-1) to (f-14), and (g-1) to (g-20). Here, in the formulae, * indicates an asymmetric carbon atom.

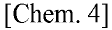

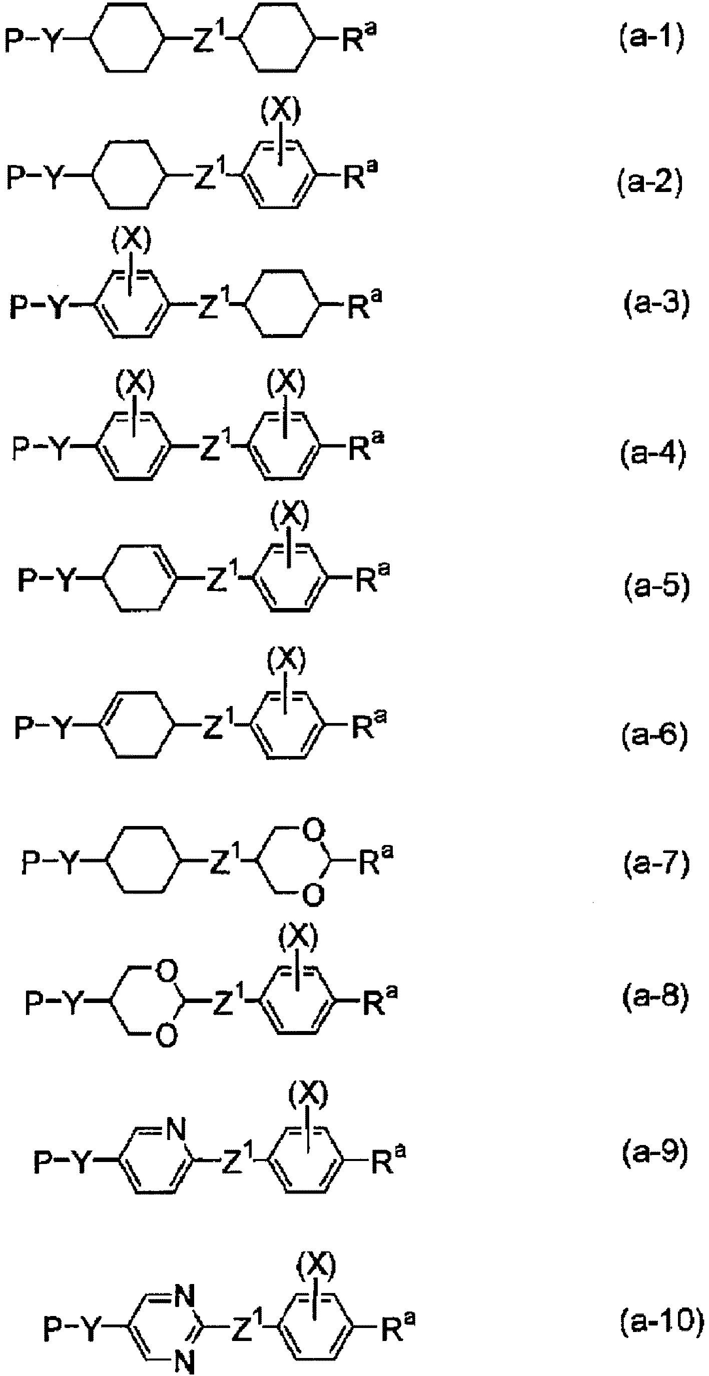

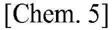

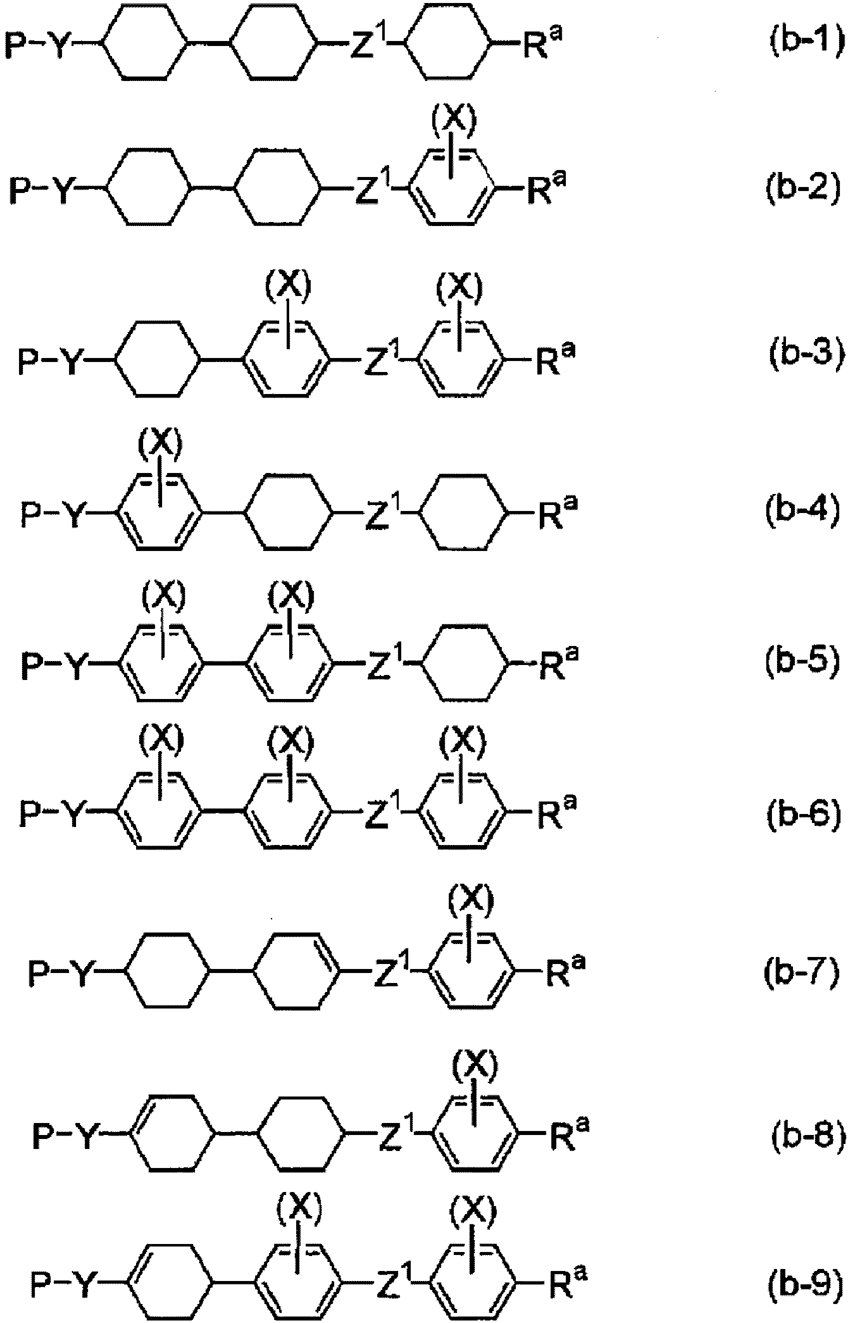

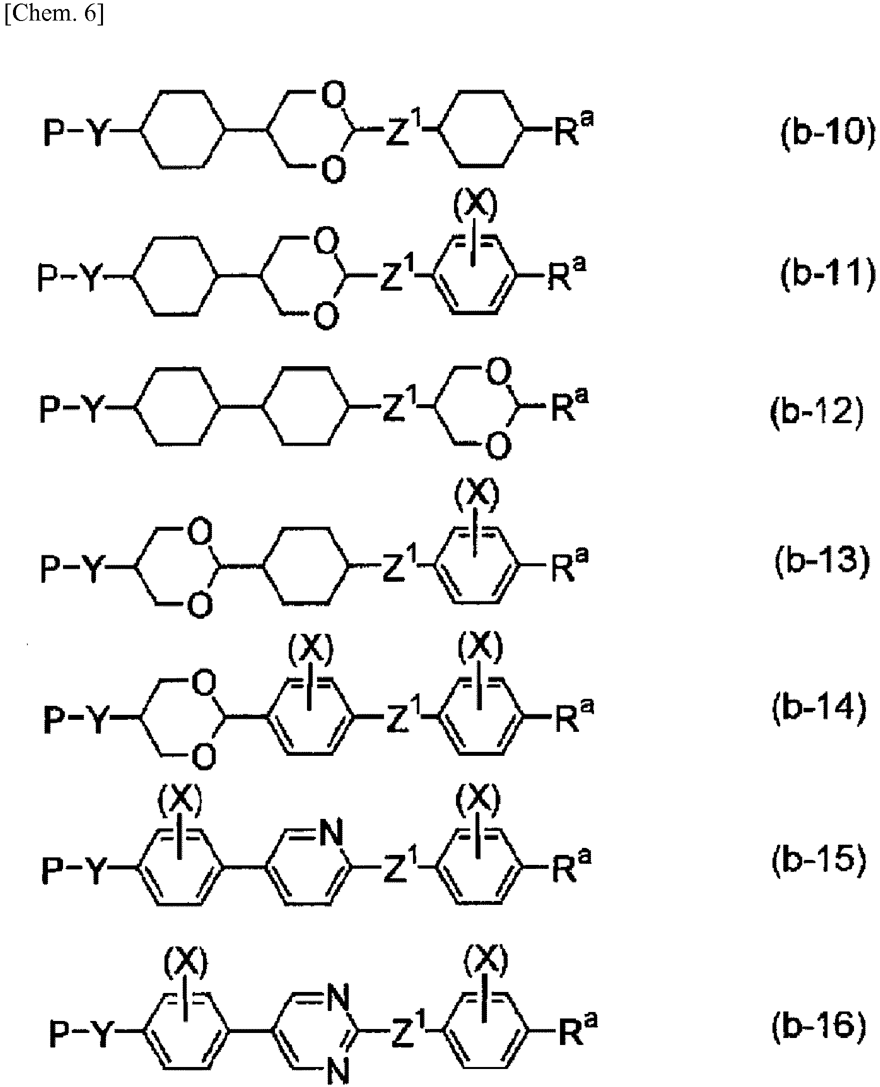

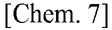

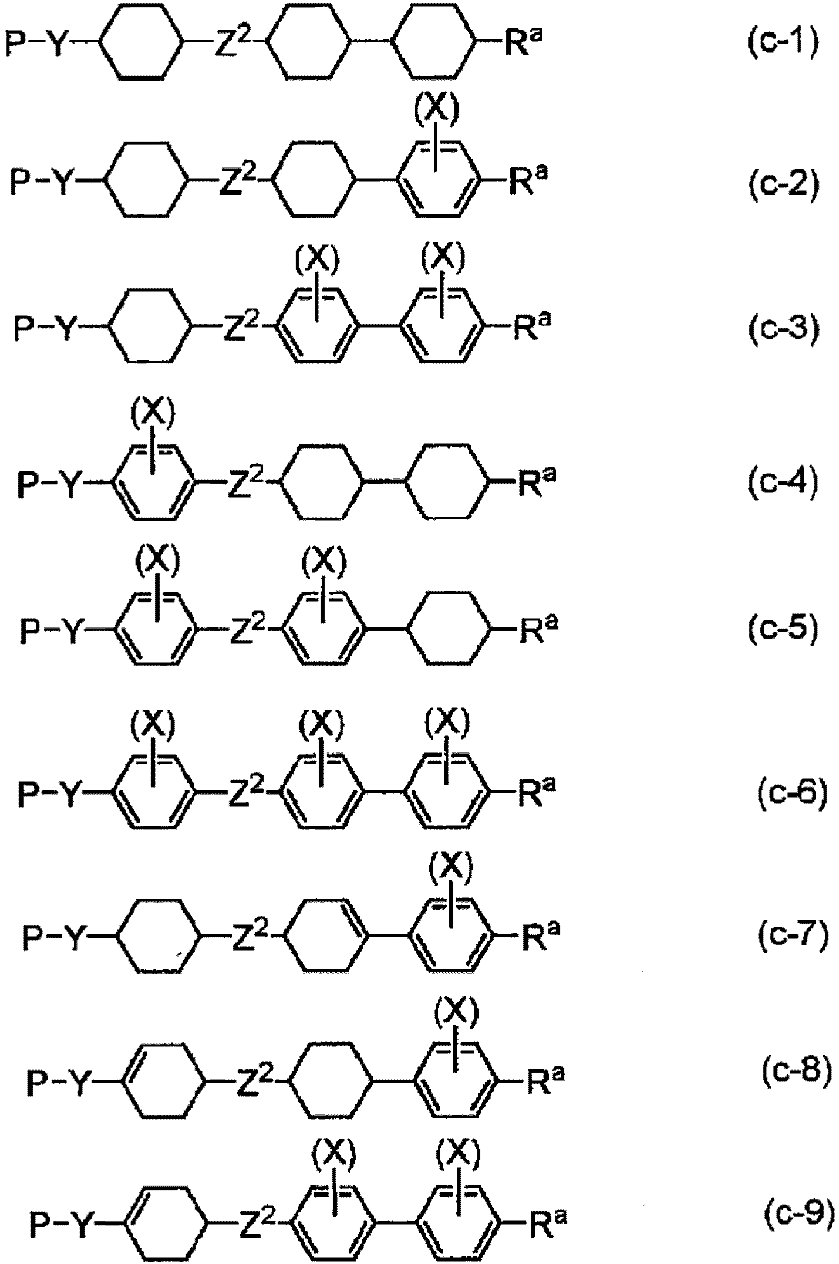

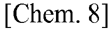

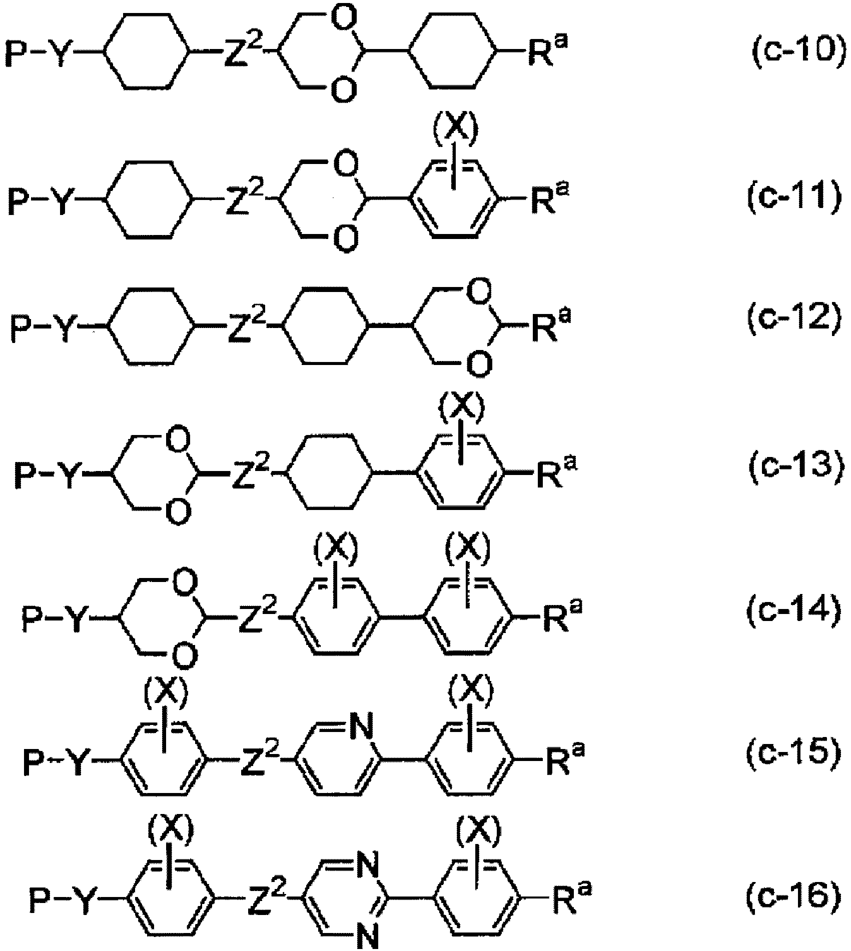

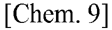

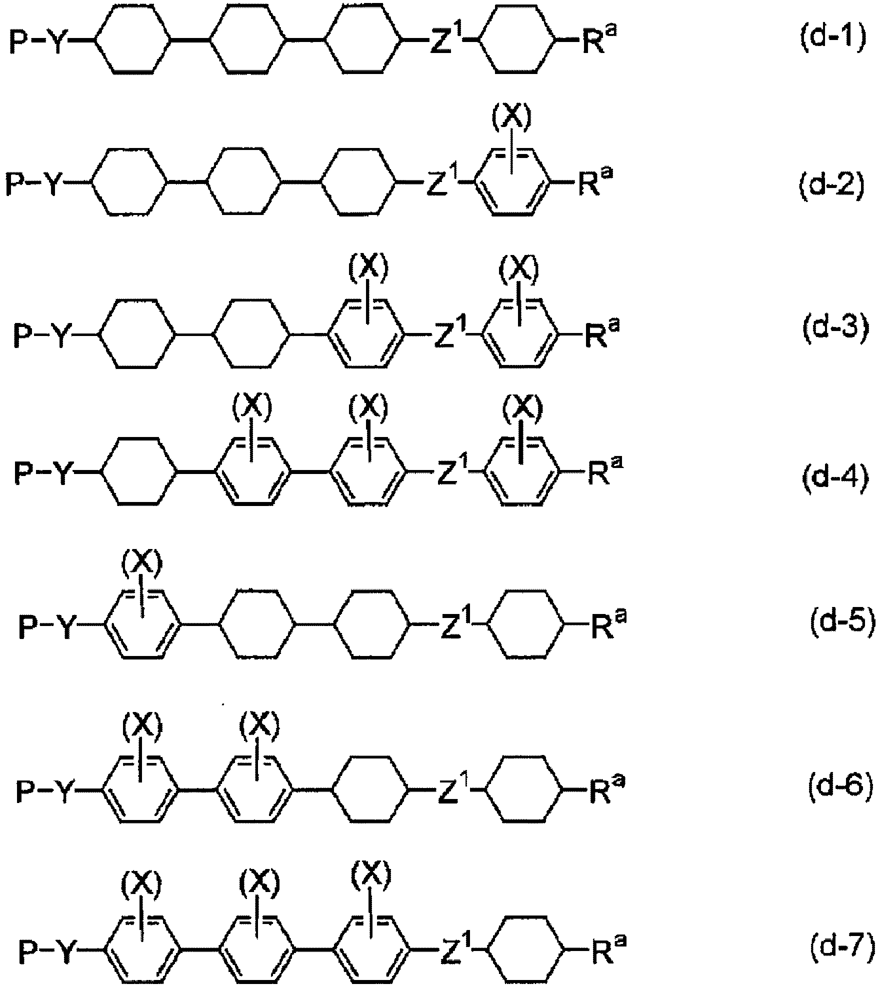

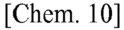

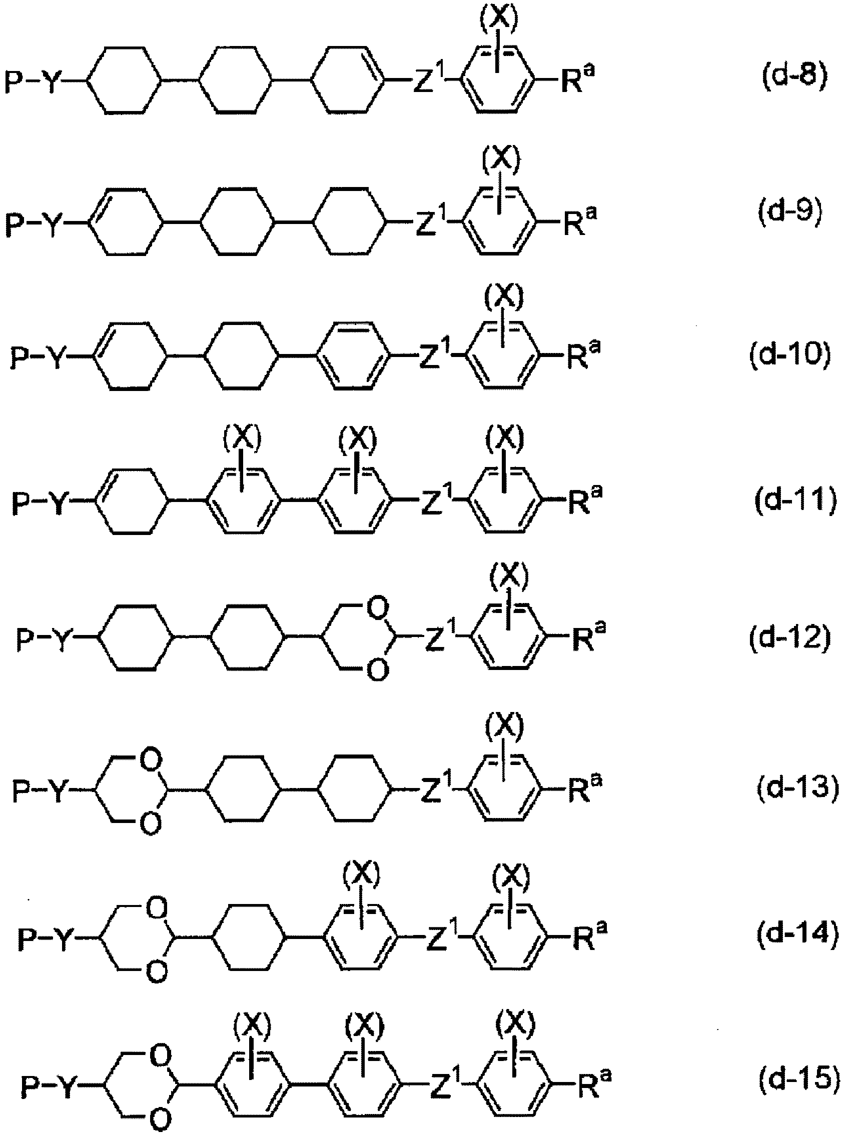

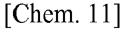

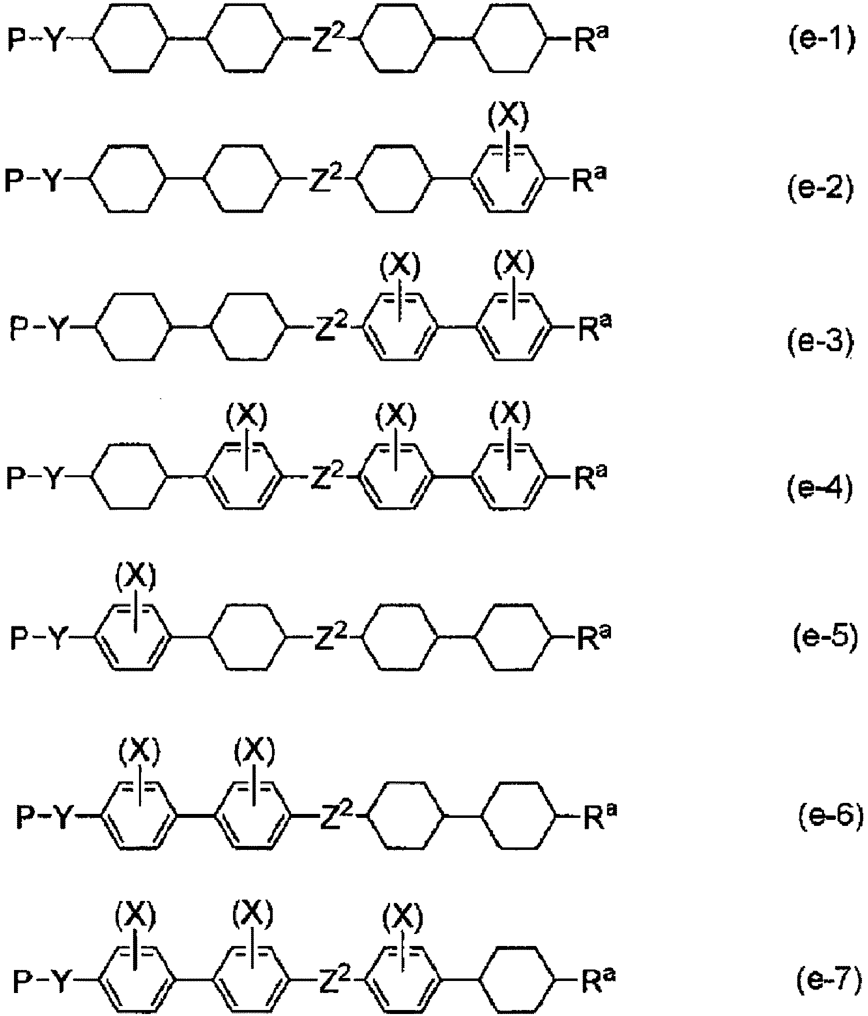

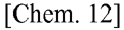

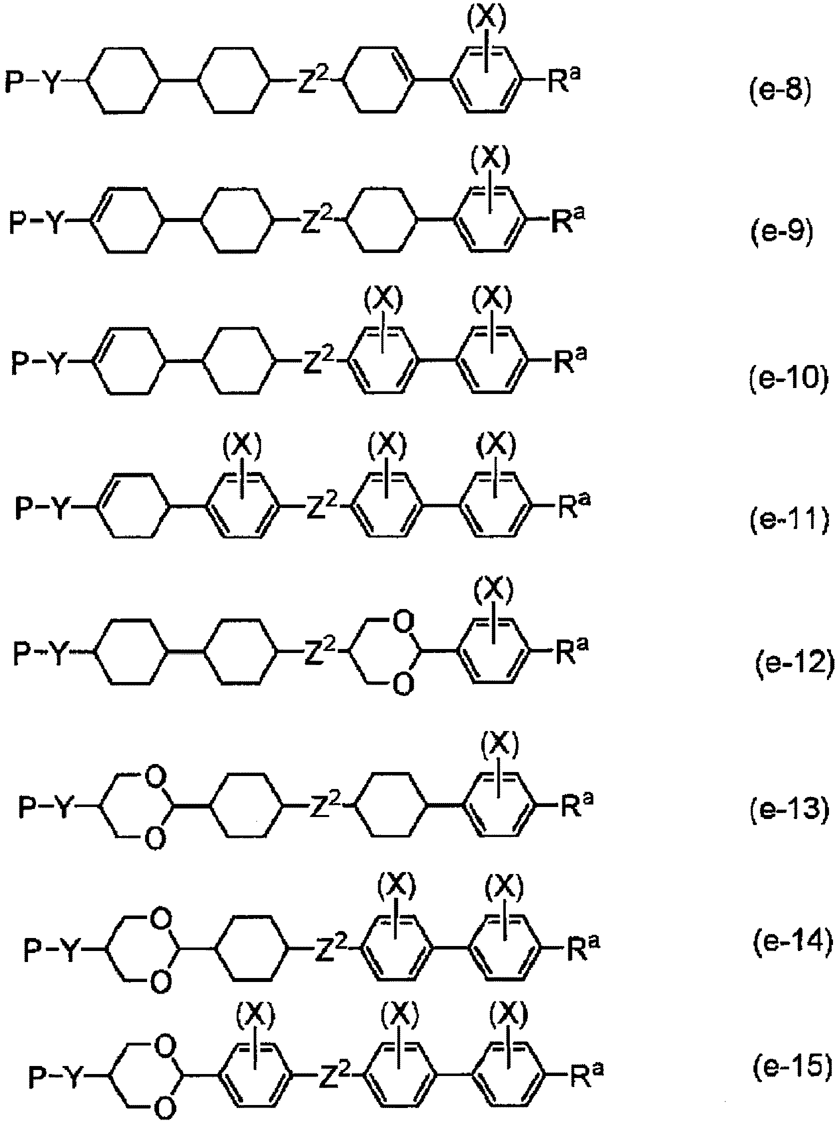

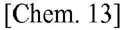

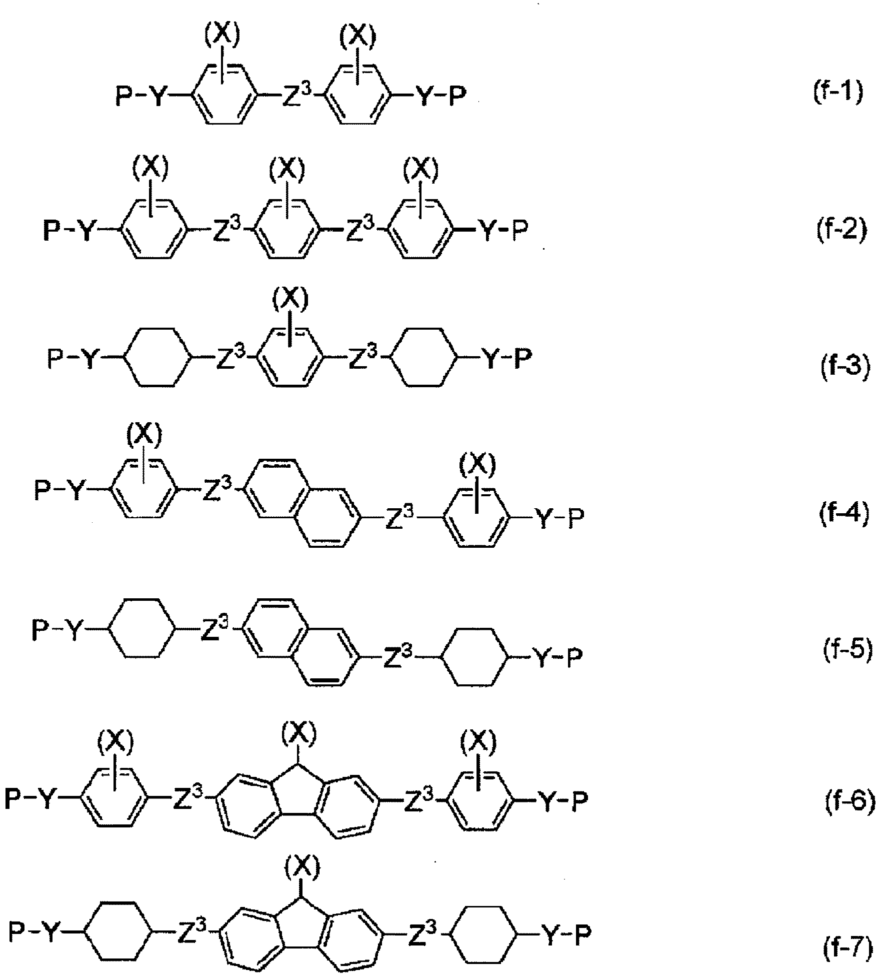

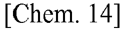

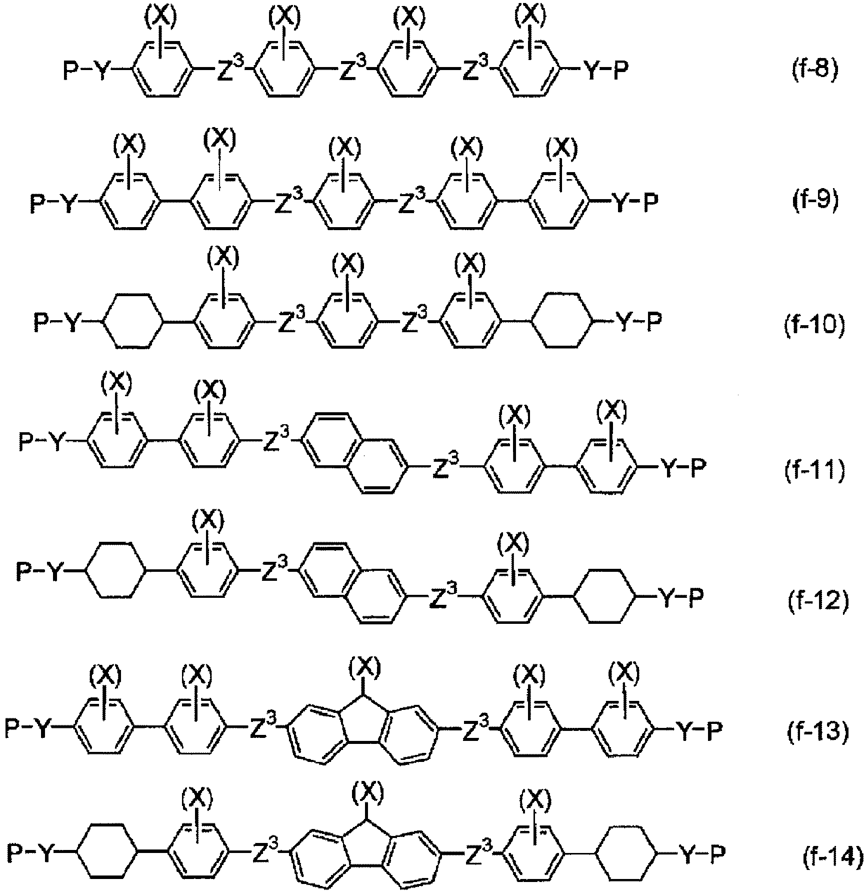

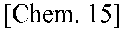

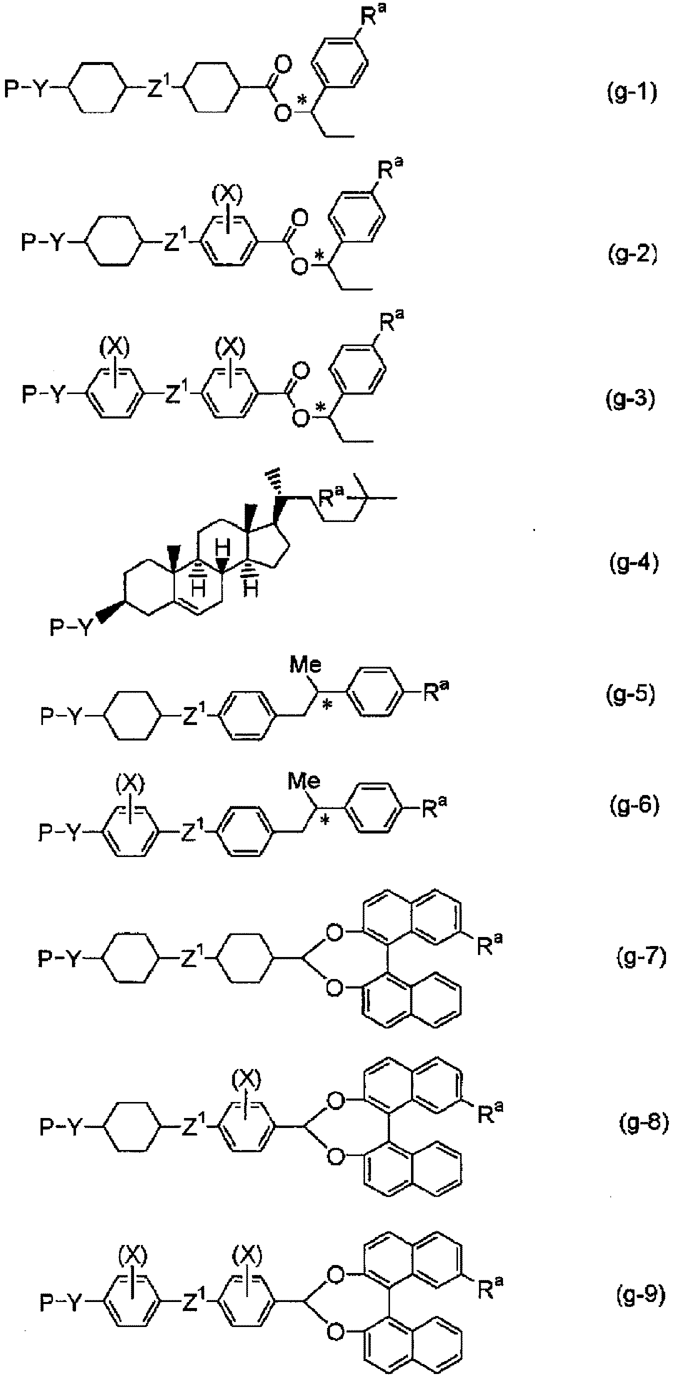

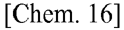

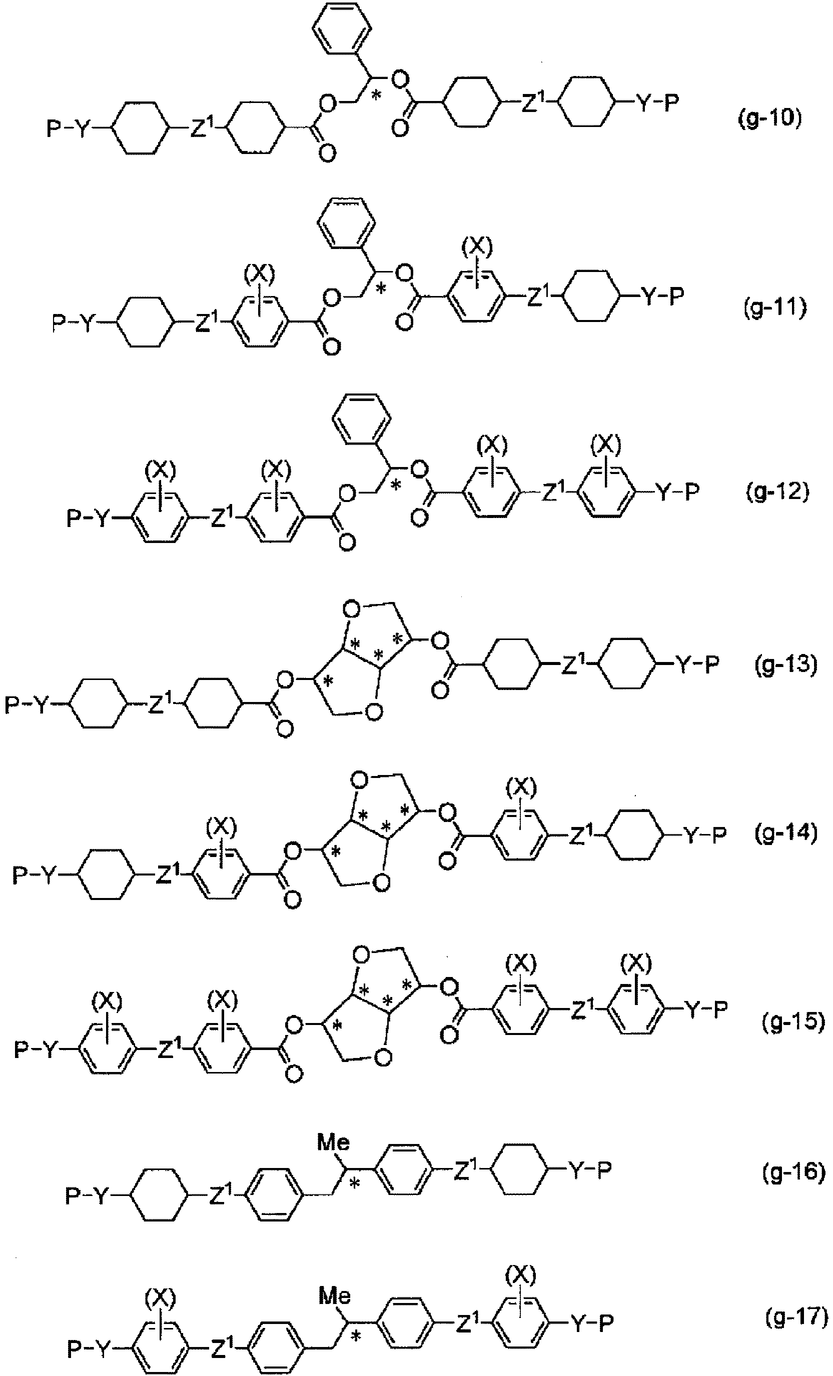

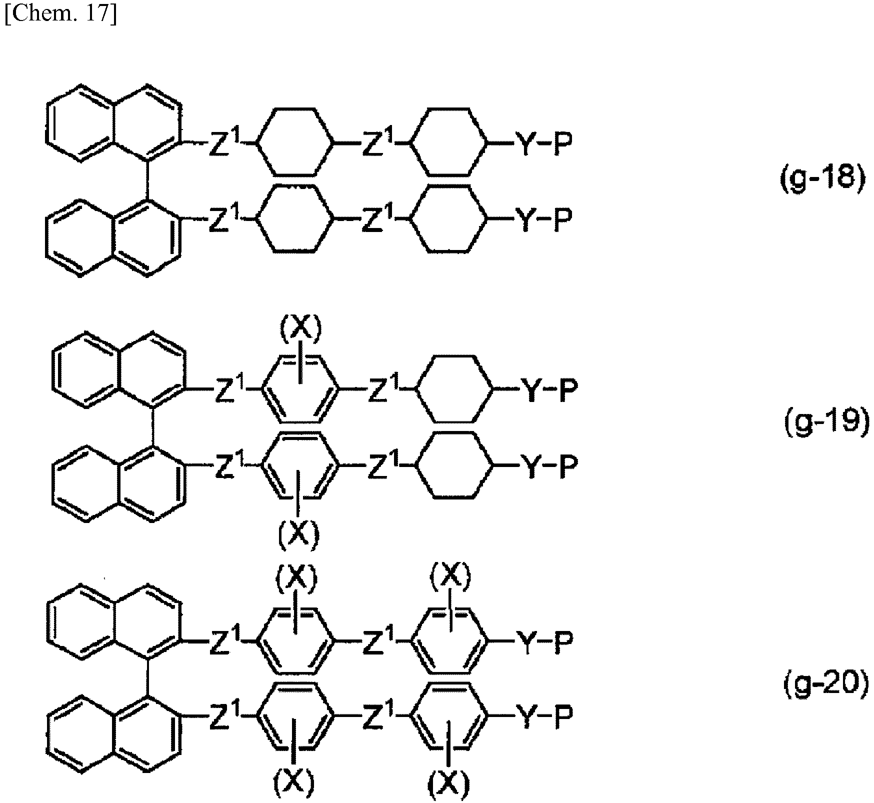

Z¹ independently represents a single bond, -(CH₂)₂-, -(CF₂)₂-, -(CH₂)₄-, -CH₂O-, -OCH₂-, -(CH₂)₃O-, -O(CH₂)₃-, -COO-, -OCO-, -CH=CH-, -CF=CF-, -CH=CHCOO-, -OCOCH=CH-, -(CH₂)₂COO-, -OCO(CH₂)₂-, -C≡C-, -C≡C-COO-, -OCO-C≡C-, -C≡C-CH=CH-, -CH=CH-C≡C-, -CH=N-, -N=CH-, -N=N-, -OCF₂- or -CF₂O-. Here, a plurality of Z¹ may be the same as or different from each other.

Z² independently represents -(CH₂)₂-, -(CF₂)₂-, -(CH₂)₄-, -CH₂O-, -OCH₂-, -(CH₂)₃O-, -O(CH₂)₃-, -COO-, -OCO-, -CH=CH-, -CF=CF-, -CH=CHCOO-, -OCOCH=CH-, -(CH₂)₂COO-, -OCO(CH₂)₂-, -C≡C-, -C≡C-COO-, -OCO-C≡C-, -C≡C-CH=CH-, -CH=CH-C≡C-, -CH=N-, -N=CH-, -N=N-, -OCF₂- or -CF₂O-.

Z³ independently represents a single bond, an alkyl group having 1 to 10 carbon atoms, -(CH₂)ₐ-, -O(CH₂)ₐO-, -CH₂O-, -OCH₂-, -O(CH₂)₃-, -(CH₂)₃O-, -COO-, -OCO-, -CH=CH-, -CH=CHCOO-, -OCOCH=CH-, -(CH₂)₂COO-, -OCO(CH₂)₂-, -CF=CF-, -C≡C-, -CH=N-, -N=CH-, -N=N-, -OCF₂- or -CF₂O-, and a plurality of Z³ may be the same as or different from each other. a is an integer of 1 to 20.

X is a substituent of 1,4-phenylene and fluorene-2,7-diyl in which any hydrogen atom is optionally substituted with a halogen atom, an alkyl group, or an alkyl fluoride, and represents a halogen atom, an alkyl group or an alkyl fluoride.

More preferable forms of Compound (1-1) will be described. A more preferable Compound (1-1) can be represented by the following Formula (1-c) or (1-d).

P¹-Y-(A-Z)ₘ-R^{a} (1-c)

P¹-Y-(A-Z)ₘ-Y-P¹ (1-d)

In the above Formulae (1-c) and (1-d), A, Z, and R^{a} have the same definitions as A, Z, and R^{a} defined in the above Formula (1-1). P¹ indicates polymerizable groups represented by the following Formulae (2-1) and (2-2), cyclohexene oxide, phthalic anhydride, or succinic anhydride, and Y is a single bond or an alkylene group having 1 to 20 carbon atoms, and preferably an alkylene group having 1 to 10 carbon atoms, and in the alkylene group, any -CH₂- is optionally substituted with -O-, -S-, -CO-, -COO-, -OCO- or -CH=CH-. A particularly preferable Y is an alkylene group in which -CH₂- at one end or both ends of an alkylene group having 1 to 10 carbon atoms is substituted with -O-. m is an integer of 1 to 6, preferably an integer of 2 to 6, and more preferably an integer of 2 to 4. In the above Formula (1-d), the two P¹ represent the same polymerizable group, the two Y represent the same group, and two Y are bonded to each other so that they are symmetric.

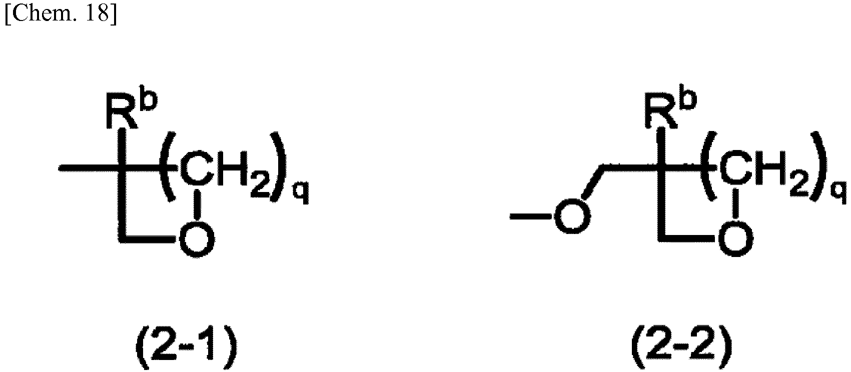

Specific examples of a more preferable Compound (1-1) are shown below.

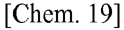

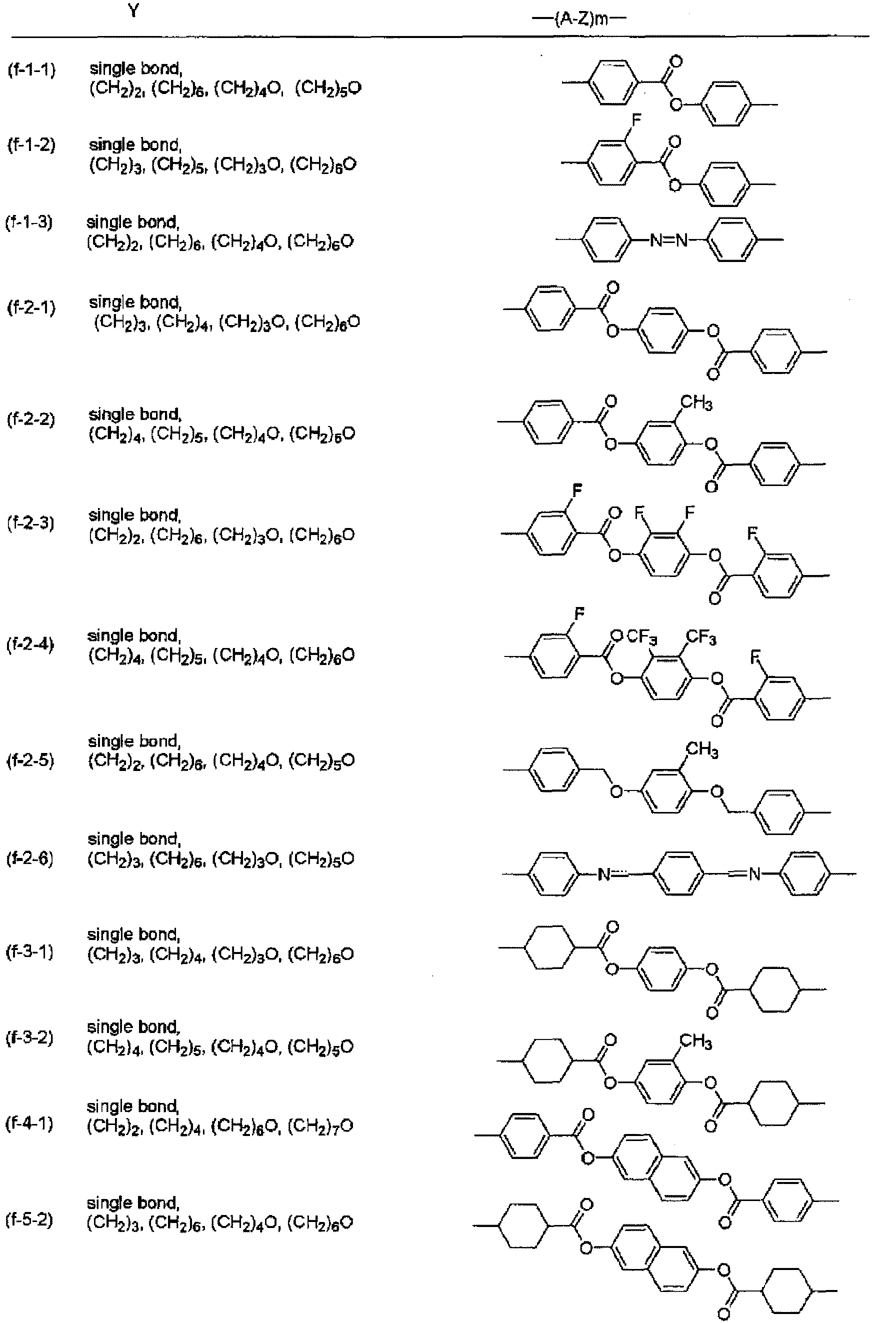

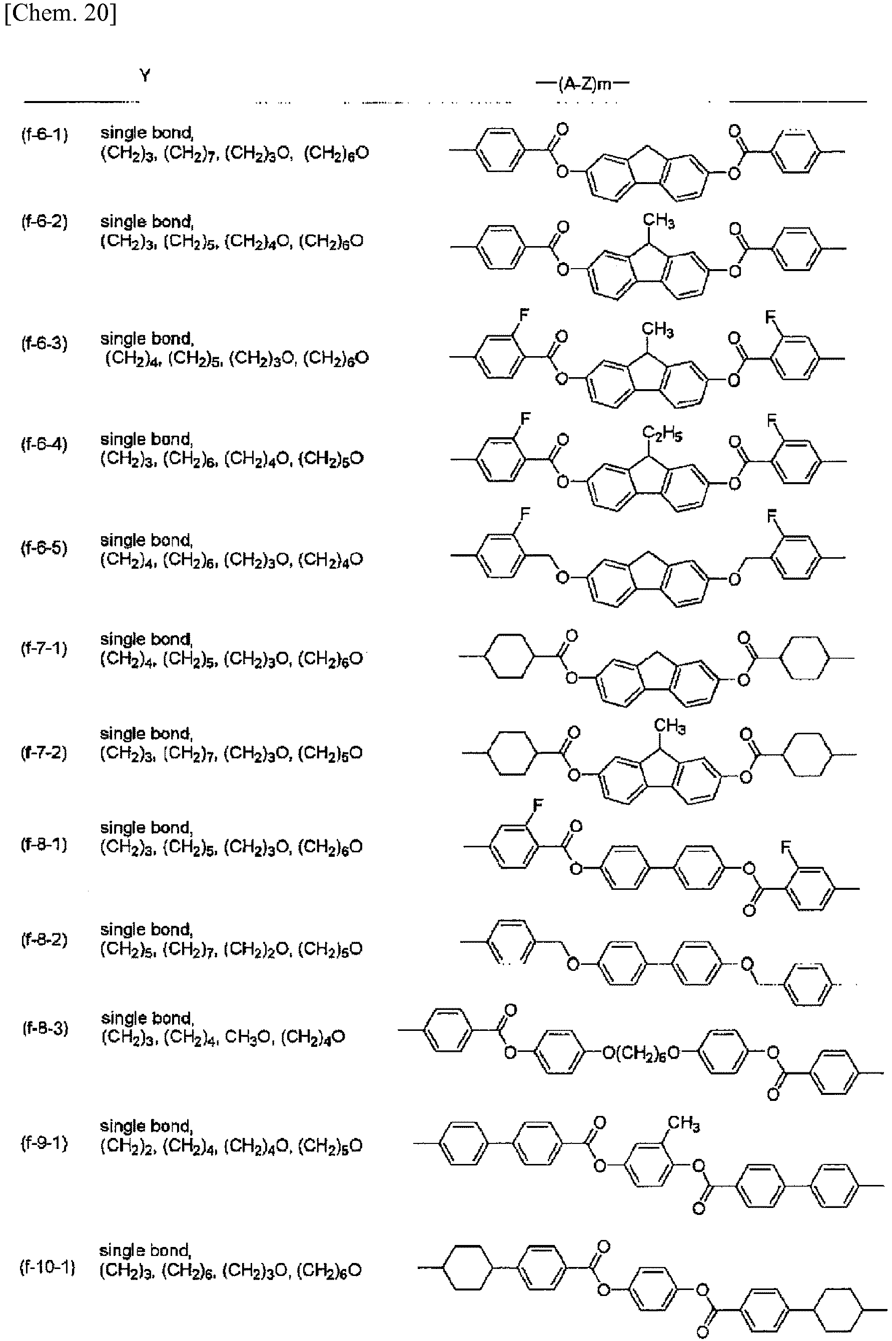

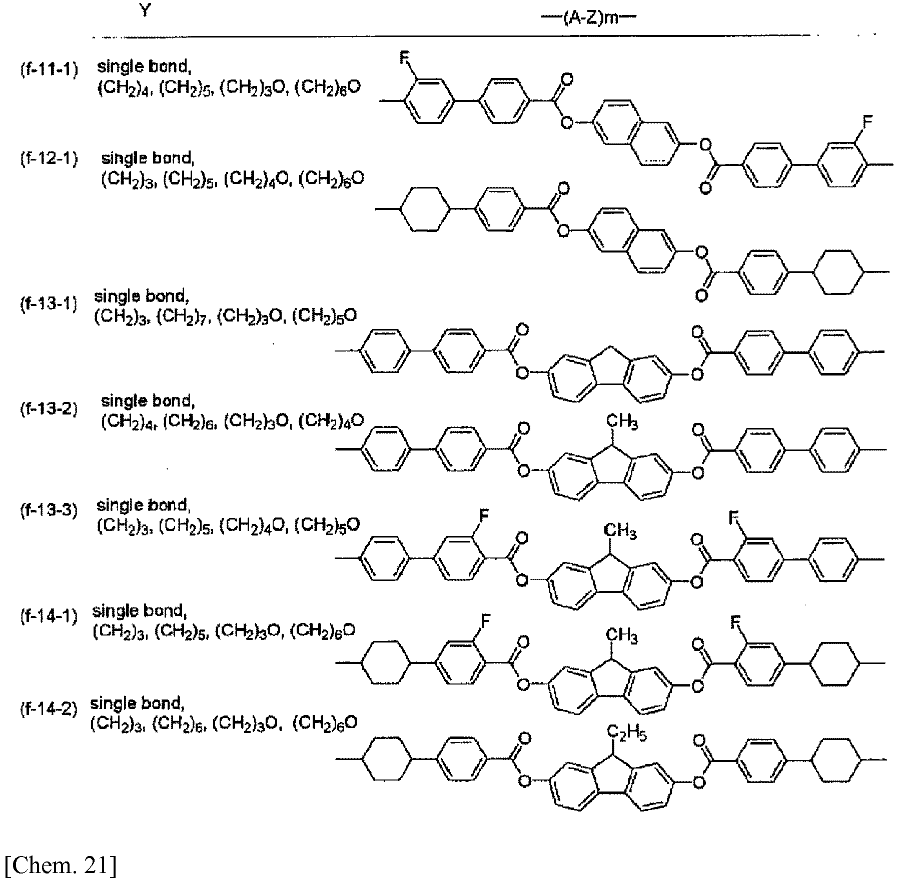

### • Method of synthesizing Compound (1-1)

Compound (1-1) can be synthesized by combining methods known in the field of organic synthetic chemistry. A method of introducing a desired terminal group, ring structure and bond group into a starting material is described in books such as, for example, Houben-Wyle (Methods of Organic Chemistry, Georg Thieme Verlag, Stuttgart), Organic Syntheses (John Wily & Sons, Inc.), Organic Reactions (John Wily & Sons Inc.), Comprehensive Organic Synthesis (Pergamon Press), and New Experimental Chemistry Course (Maruzen). In addition, Japanese Unexamined Patent Application Publication No. 2006-265527 may be referred to.

The bifunctional or higher polymerizable compound (hereinafter simply referred to as a "polymerizable compound" in some cases) may be a polymerizable compound that does not exhibit liquid crystallinity other than the polymerizable liquid crystal compound represented by the above Formula (1-1). For example, polyether diglycidyl ether, bisphenol A diglycidyl ether, bisphenol F diglycidyl ether, biphenol diglycidyl ether, and a compound that has insufficient linearity and exhibits no liquid crystallinity among compounds of Formula (1-1) may be exemplified. A compound having higher linearity does not interfere with phonon conduction of heat transmitted through a molecular chain, and thus an effect of increasing thermal conductivity can be expected. However, a compound having lower linearity has an advantage of ease of handling because a melting point is low.

The polymerizable compound can be synthesized by combining methods known in the field of organic synthetic chemistry.

The polymerizable compound used in the present invention preferably has a bifunctional or higher functional group for forming a bond with a coupling agent, a trifunctional or higher functional group, or a tetrafunctional or higher functional group. In addition, a compound having a functional group at both ends of the long side of the polymerizable compound is preferable because a linear bond can then be formed.

### <Inorganic fillers>

Examples of the first inorganic filler and the second inorganic filler include a metal oxide, a silicate mineral, a silicon carbide, and a silicon nitride. The first inorganic filler and the second inorganic filler may be the same as or different from each other.

Specifically, examples of the first inorganic filler and the second inorganic filler include alumina, zirconia, silica, magnesium oxide, zinc oxide, iron oxide, ferrite, mullite, cordierite, silicon carbide, and silicon nitride.

Examples of a third inorganic filler include inorganic fillers and metal fillers such as alumina, zirconia, silica, boron nitride, boron carbide, aluminum nitride, silicon nitride, silicon carbide, diamond, carbon nanotubes, graphite, graphene, gold, silver, copper, platinum, iron, tin, lead, nickel, aluminum, magnesium, tungsten, molybdenum, and stainless steel, which have high thermal conductivity and a smaller size than the first and the second inorganic fillers.

It is desirable that a structure of the polymerizable compound have a shape and a length at which these inorganic fillers can be efficiently directly bonded to each other. A type, a shape, a size, and an addition amount of the third inorganic filler can be appropriately selected depending on the purpose. When insulation properties are necessary for the obtained low thermal expansion member, an inorganic filler having conductivity may be used as long as desired insulation properties are maintained. Examples of the shape of the third inorganic filler include a plate shape, a spherical shape, an amorphous shape, a fibrous shape, a rod shape, and a tubular shape.

As the first inorganic filler and the second inorganic filler, alumina, zirconia, magnesium oxide, zinc oxide, iron oxide, ferrite, mullite, cordierite, silicon carbide, and silicon nitride are preferable. Alumina, zinc oxide, cordierite, silicon nitride, and silicon carbide are more preferable. Alumina, zinc oxide, and silicon nitride are preferable because they have high thermal conductivity and strong insulation properties. Cordierite does not have very high thermal conductivity but it is preferable because it has a small thermal expansion coefficient. Among these, spherical alumina is particularly preferable because it has low anisotropy and can form a composite material of which a thermal expansion coefficient is close to that of a member inside a semiconductor device such as copper and SiC, and has high mechanical strength, high chemical stability, and is inexpensive. In use for applications for which anisotropy is necessary, in addition to features of the alumina, plate-like alumina or needle-like alumina is aligned and used, and thus it is possible to form a member having excellent strength and thermal conductivity in the alignment direction.

As the third inorganic filler, preferably, in addition to inorganic fillers which are the same type as the first and second inorganic fillers such as zinc oxide and silicon nitride and have a small particle size, different types of fillers having high thermal conductivity such as boron nitride, aluminum nitride, graphite, carbon fibers, carbon nanotubes, and graphene may be exemplified. In particular, boron nitride and aluminum nitride having a small particle system are preferable. Boron nitride, aluminum nitride, carbon nanotubes, graphite, and graphene have very high thermal conductivity. Boron nitride and aluminum nitride are preferable because they have strong insulation properties. For example, carbon nanotubes or graphene having a length such that fillers are bonded according to a fiber length is preferably used because not only fillers are bonded to each other using a silane coupling agent and a polymerizable liquid crystal compound, but also thermal bonding is possible using carbon nanotubes having very high thermal conductivity, and thus overall thermal conductivity can increase.

An average particle size of the inorganic filler is preferably 0.1 to 200 µm, and more preferably, 1 to 100 µm. When the average particle size is 0.1 µm or more, thermal conductivity is favorable, and when the average particle size is 200 µm or less, a filling rate can increase.

Here, in this specification, the average particle size is based on particle size distribution measurement using a laser diffraction and scattering method. That is, using analysis according to the Fraunhofer diffraction theory and the Mie scattering theory, powder is divided into two sides with respect to a certain particle size using a wet method, and a size at which the larger side and the smaller side are equal (based on the volume) is set as a median size.

Proportions of the inorganic filler, the coupling agent, and the polymerizable compound depend on an amount of the coupling agent bonded to the inorganic filler used. A surface of a compound (for example, alumina) used as the first and second inorganic fillers is modified with a silane coupling agent, but if a modification amount is too small, the number of bonds between fillers is excessively small, and thus mechanical strength is low. On the other hand, when a modification amount is excessively large, since the filler is surrounded by a great amount of a polymerizable compound, characteristics of the filler are unlikely to be exhibited on the surface, and physical properties of a general resin are exhibited. In order to make the thermal expansion coefficient small and increase the thermal conductivity, a volume ratio between a silane coupling agent and a polymerizable compound in a cured product, and an inorganic component is desirably in a range of 5:95 to 30:70, and more desirably in a range of 10:90 to 25:75. The inorganic component is an inorganic raw material before a silane coupling agent treatment or the like is performed.

### <Coupling agent>

In a coupling agent bonded to the inorganic filler, when a functional group of a bifunctional or higher polymerizable compound is oxiranyl, acid anhydride, or the like, since it is preferable that the coupling agent react with these functional groups, it is preferable that the coupling agent have an amine reactive group at the terminus. Examples of the coupling agent include Sila-Ace (registered trademark) S310, S320, S330, and S360 (commercially available from JNC) and KBM903 and KBE903 (commercially available from Shin-Etsu Chemical Co., Ltd.).

Here, when the terminus of the bifunctional or higher polymerizable compound is an amine, a coupling agent having an oxiranyl group or the like at the terminus is preferable. Examples of the coupling agent include Sila-Ace (registered trademark) S510 and S530 (commercially available from JNC).

The first coupling agent and the second coupling agent may be the same as or different from each other.

As the first inorganic filler, an inorganic filler that is treated with a coupling agent and then additionally subjected to surface modification with a bifunctional or higher polymerizable compound is used. For example, in an inorganic filler (inorganic filler bonded to a coupling agent) treated with a silane coupling agent, a bifunctional or higher polymerizable compound may be additionally bonded to the coupling agent, and thus the inorganic filler is subjected to surface modification with a polymerizable compound. As shown in FIG. 2, the first inorganic filler subjected to surface modification with a polymerizable compound can form a bond with the second inorganic filler using the polymerizable compound and the coupling agent, and the bond greatly contributes to thermal conduction.

As the bifunctional or higher polymerizable compound, the bifunctional or higher polymerizable liquid crystal compound represented by the above Formula (1-1) is preferable. However, other polymerizable liquid crystal compounds may be used, and a polymerizable compound having no liquid crystallinity may be used. When the polymerizable compound is polycyclic, this is desirable because heat resistance is high, and when the linearity is high, elongation and fluctuation between inorganic fillers due to heat are small, and moreover, it is possible to efficiently transfer phonons in heat conduction. When the polymerizable compound is polycyclic and has high linearity, liquid crystallinity is exhibited as a result in many cases. Therefore, it can be said that thermal conductivity is improved if the polymerizable compound has liquid crystallinity.

### <Other components>

The composition for a low thermal expansion member may further contain an organic compound (for example, a polymerizable compound or a polymer compound) that is not bonded to the first inorganic filler or the second inorganic filler, that is, does not contribute to bonding, and may contain a polymerization initiator, a solvent, and the like.

### <Polymerizable compound that is not bonded>

The composition for a low thermal expansion member may contain a polymerizable compound (in this case, it need not be a bifunctional or higher polymerizable compound) that is not bonded to an inorganic filler as a component. As such a polymerizable compound, a compound that does not prevent thermal curing of the inorganic filler and does not evaporate or bleed out due to heat is preferable. Such polymerizable compounds are classified into compounds having no liquid crystallinity and compounds having liquid crystallinity. Examples of the polymerizable compound having no liquid crystallinity include vinyl derivatives, styrene derivatives, (meth)acrylic acid derivatives, sorbic acid derivatives, fumaric acid derivatives, and itaconic acid derivatives. Regarding a content, first, desirably, a composition for a low thermal expansion member that does not contain a polymerizable compound that is not bonded is produced, a porosity thereof is measured, and the polymerizable compound is added in an amount at which voids are filled.

### <Polymer compound that is not bonded>

The composition for a low thermal expansion member may contain a polymer compound that is not bonded to an inorganic filler as a component. As such a polymer compound, a compound that does not degrade film forming properties and mechanical strength is preferable. The polymer compound may be a polymer compound that does not react with the inorganic filler, the coupling agent, and the polymerizable compound. For example, when the polymerizable compound is an oxiranyl and the silane coupling agent has an amino group, a polyolefin resin, a polyvinyl resin, a silicone resin, a wax, and the like may be exemplified. Regarding a content, first, desirably, a composition for a low thermal expansion member that does not contain a polymer compound that is not bonded is produced, a porosity thereof is measured, and the polymer compound is added in an amount at which voids are filled.

### <Non-polymerizable liquid crystalline compound>

The composition for a low thermal expansion member may contain a liquid crystalline compound having no polymerizable group as a component. Examples of such a non-polymerizable liquid crystalline compound are described in the liquid crystalline compound database LiqCryst (LCI Publisher GmbH, Hamburg, Germany), and the like. When the composition containing a non-polymerizable liquid crystalline compound is polymerized, for example, it is possible to obtain composite materials of the polymer of Compound (1-1) and the liquid crystalline compound. In such composite materials, a non-polymerizable liquid crystalline compound is present in a polymer network such as a polymer dispersed liquid crystal. Therefore, a liquid crystalline compound having properties such that it has no fluidity in a temperature range in which it is used is desirable. Combining may be performed in such a manner in which, after the inorganic filler is cured, it is injected into voids in a temperature range in which an isotropic phase is exhibited or inorganic fillers may be polymerized by mixing in an amount of the liquid crystalline compound computed in advance such that voids are filled in the inorganic fillers.

### <Polymerization initiator>

The composition for a low thermal expansion member may contain a polymerization initiator as a component. As the polymerization initiator, according to components and a polymerization method of the composition, for example, a photo radical polymerization initiator, a photocationic polymerization initiator, and a thermal radical polymerization initiator may be used. In particular, since the inorganic filler absorbs ultraviolet rays, a thermal radical polymerization initiator is preferable.

Examples of a preferable initiator for thermal radical polymerization include benzoyl peroxide, diisopropyl peroxydicarbonate, t-butylperoxy-2-ethylhexanoate, t-butyl peroxypivalate, di-t-butyl peroxide (DTBPO), t-butyl peroxydiisobutyrate, lauroyl peroxide, dimethyl 2,2'-azobisisobutyrate (MAIB), azobisisobutyronitrile (AIBN), and azobiscyclohexanecarbonitrile (ACN).

### <Solvent>

The composition for a low thermal expansion member may contain a solvent. When a component that needs to be polymerized is contained in the composition, polymerization may be performed in a solvent or without a solvent. The composition containing a solvent may be applied onto a substrate, using, for example, a spin coating method, and then photopolymerized after the solvent is removed. Alternatively, after photocuring, heating may be performed to an appropriate temperature, curing may be performed by heating and thus a post treatment may be performed.

Examples of a preferable solvent include benzene, toluene, xylene, mesitylene, hexane, heptane, octane, nonane, decane, tetrahydrofuran, γ-butyrolactone, N-methyl pyrrolidone, dimethylformamide, dimethylsulfoxide, cyclohexane, methylcyclohexane, cyclopentanone, cyclohexanone, and PGMEA. The above solvents may be used alone, or two or more types thereof may be used in combination.

Here, there is little point in limiting a proportion of a solvent used during polymerization. In consideration of polymerization efficiency, solvent cost, energy cost, and the like, the proportion may be determined for each case.

### <Others>

In order to facilitate handling, a stabilizer may be added to the composition for a low thermal expansion member. As such a stabilizer, a known stabilizer can be used without limitation. Examples of the stabilizer include hydroquinone, 4-ethoxyphenol, and 3,5-di-t-butyl-4-hydroxytoluene (BHT).

In addition, an additive (such as an oxide) may be added in order to adjust the viscosity or color of the composition for a low thermal expansion member. For example, titanium oxide for exhibiting white, carbon black for exhibiting black, and a fine silica powder for adjusting the viscosity can be exemplified. In addition, an additive may be added in order to further increase mechanical strength. For example, as inorganic fibers such as glass fibers, carbon fibers, and carbon nanotubes, cloth, or a polymer additive, fibers or long molecules of polyvinyl formal, polyvinyl butyral, polyester, polyamide, and polyimide may be exemplified.

### [Production method]

A method of producing a composition for a low thermal expansion member, and a method of producing a low thermal expansion member from the composition will be described below in detail.

### (1) Preforming a coupling treatment

A coupling treatment is performed on an inorganic filler, and a form in which one end of a coupling agent is bonded to an inorganic filler is referred to as a second inorganic filler. The coupling treatment can be performed using a known method.

As an example, first, the inorganic filler and the coupling agent are added to a solvent. After stirring is performed using a stirrer or the like, drying is performed. After the solvent is dried, a heat treatment is performed under vacuum conditions using a vacuum dryer or the like. A solvent is added to the inorganic filler and pulverization is performed using an ultrasonic treatment. This solution is separated and purified using a centrifuge. After the supernatant is discarded, the solvent is added, and the same operation is performed several times. The inorganic filler subjected to a coupling treatment after purification is dried using an oven. (2) Modification with polymerizable compound

A bifunctional or higher polymerizable compound is bonded to the other end of the coupling agent of the inorganic filler (that may be the same as or different from the above second inorganic filler) subjected to a coupling treatment. The inorganic filler modified with the polymerizable compound in this manner is referred to as a first inorganic filler.

As an example, the inorganic filler subjected to a coupling treatment and a bifunctional or higher polymerizable compound are mixed using an agate mortar or the like, and kneading is then performed using two rollers. Then, separation and purification are performed through an ultrasonic treatment and centrifugation.

### (3) Mixing

The first inorganic filler and the second inorganic filler are weighed out such that, for example, weights of only the inorganic fillers are 1:1, and mixing is performed using an agate mortar or the like. Then, mixing is performed using two rollers or the like, and a composition for a low thermal expansion member is obtained.

Regarding a mixing ratio between the first inorganic filler and the second inorganic filler, when bond groups that form a bond between the first inorganic filler and the second inorganic filler are amine:epoxy, for example, weights of only the inorganic fillers are preferably 1:1 to 1:30 (weight ratio), and more preferably 1:3 to 1:20. The mixing ratio is determined according to the number of terminal bond groups that form a bond between the first inorganic filler and the second inorganic filler. For example, in the case of a secondary amine, since it can react with two oxiranyl groups, it may be used in a smaller amount compared to the oxiranyl side, and since the oxiranyl side may be ring-opened, a greater amount than that computed from the epoxy equivalent is preferably used.

### (4) Producing a low thermal expansion member

As an example, a method of producing a film as a low thermal expansion member using a composition for a low thermal expansion member will be described. A composition for a low thermal expansion member is inserted between heating plates using a compression molding machine and aligned, cured and molded by compression molding. In addition, post-curing is performed using an oven or the like, and a low thermal expansion member of the present invention is obtained. Here, a pressure during compression molding is preferably 50 to 200 kgf/cm² and more preferably 70 to 180 kgf/cm². Basically, a higher pressure during curing is preferable. However, a pressure is appropriately changed according to the fluidity of the mold and desired physical properties (in which direction to emphasize the thermal conductivity in), and an appropriate pressure is preferably applied.

Hereinafter, a method of producing a film as a low thermal expansion member using a composition for a low thermal expansion member containing a solvent will be described in detail.

First, the composition is applied to the substrate, the solvent is dried and removed, and a coating layer with a uniform film thickness is formed. Examples of the coating method include spin coating, roll coating, curtain coating, flow coating, printing, micro gravure coating, gravure coating, wire bar coating, dip coating, spray coating, and a meniscus coating method.

The solvent can be dried and removed by, for example, air-drying at room temperature, drying on a hot plate, drying in a drying furnace, blowing warm air or hot air, or the like. Conditions for removing the solvent are not particularly limited, and it is sufficient to perform drying until the solvent is substantially removed and the fluidity of a coating layer disappears.

Examples of the substrate include metal substrates of copper, aluminum, iron and the like; inorganic semiconductor substrates of silicon, silicon nitride, gallium nitride, and zinc oxide; glass substrates of alkali glass, borosilicate glass, and flint glass, and inorganic insulating substrates of alumina and aluminum nitride; and plastic film substrates of polyimide, polyamideimide, polyamide, polyetherimide, polyether ether ketone, polyether ketone, polyketone sulfide, polyethersulfone, polysulfone, polyphenylene sulfide, polyphenylene oxide, polyethylene terephthalate, polybutylene terephthalate, polyethylene naphthalate, polyacetal, polycarbonate, polyarylate, an acrylic resin, polyvinyl alcohol, polypropylene, cellulose, triacetyl cellulose, and partially saponified products thereof, and an epoxy resin, a phenol resin, a norbornene resin, and the like.

The film substrate may be a uniaxially stretched film or a biaxially stretched film. The film substrate may be subjected to a surface treatment such as a saponification treatment, a corona treatment, or a plasma treatment in advance. Here, on such film substrates, a protective layer that is not affected by the solvent contained in the composition for a low thermal expansion member may be formed. Examples of a material used for the protective layer include a polyvinyl alcohol. In addition, an anchor coat layer may be formed in order to improve the adhesion between the protective layer and the substrate. For such an anchor coat layer, any of inorganic and organic materials may be used as long as it can improve the adhesion between the protective layer and the substrate.

A case in which a bond between the inorganic fillers is composed of an inorganic filler subjected to a coupling treatment and an inorganic filler that is subjected to a coupling treatment and further modified with a polymerizable compound has been described above. Specifically, for example, the second inorganic filler is subjected to a coupling treatment using a silane coupling agent having an amino group. After the first inorganic filler is subjected to a coupling treatment using a silane coupling agent having an amino group, the amino group and one end of the bifunctional or higher polymerizable compound having an epoxy group at both ends are bonded to each other. Finally, the amino group on the side of the second inorganic filler and the other epoxy group of the polymerizable compound on the side of the first inorganic filler are bonded to each other (refer to FIG. 2). Here, a combination in which the inorganic filler side has an epoxy group and the polymerizable compound side had an epoxy group may be used.

As another method, a coupling agent modified with a bifunctional or higher polymerizable compound in advance can be used. For example, the second inorganic filler is subjected to a coupling treatment using a silane coupling agent having an amino group. Next, a silane coupling agent having a vinyl group is modified with a polymerizable compound having a vinyl group and an epoxy group at the terminus, and the first inorganic filler is then subjected to a coupling treatment using the modified silane coupling agent. Finally, the amino group on the side of the second inorganic filler and the epoxy group of the polymerizable compound on the side of the first inorganic filler are bonded to each other.

In addition, as another method, the first and second inorganic fillers treated with a coupling agent and the bifunctional or higher polymerizable liquid crystal compound (such as a liquid crystal epoxy compound) computed from an amount of modification of the coupling agent may be mixed and pressed. When heating is performed while performing pressing, first, the polymerizable liquid crystal compound is brought into a liquid crystal state and enters gaps of the inorganic fillers. When additional heating is performed, a bond between the first inorganic filler and the second inorganic filler can be formed (that is, cured).

For example, as shown in FIG. 3, the composition for a low thermal expansion member may be a composition including a first inorganic filler 1 bonded to one end of a first coupling agent 11 and a second inorganic filler 2 bonded to one end of a second coupling agent 12. The other end of the first coupling agent 11 and the other end of the second coupling agent 12 are not bonded to each other.

As shown in FIG. 3, when the composition for a low thermal expansion member is cured, the other end of the first coupling agent 11 is bonded to the other end of the second coupling agent 12.

In this manner, a bond between the inorganic fillers may be formed according to a bond between coupling agents without using a polymerizable compound. For example, the first inorganic filler is subjected to a coupling treatment using a silane coupling agent having an amino group. The second inorganic filler is subjected to a coupling treatment using a silane coupling agent having an epoxy group. Finally, the amino group on the side of the first inorganic filler and the epoxy group on the side of the second inorganic filler are bonded to each other. In this manner, the coupling agent bonded to the first inorganic filler and the coupling agent bonded to the second inorganic filler each have a functional group for bonding coupling agents. The functional group on the side of the first inorganic filler and the functional group on the side of the second inorganic filler may be a combination of different types of functional groups or a combination of the same type of functional group as long as it is possible to bond coupling agents to each other.

Examples of a combination of functional groups that form a bond between coupling agents include a combination of an oxiranyl group and an amino group, a combination of vinyl groups, a combination of methacryloxy groups, a combination of a carboxy or carboxylic acid anhydride residue and an amino group, and a combination of imidazole and an oxiranyl group, but the present invention is not limited thereto. A combination with high heat resistance is more preferable.

In a form in which a bond between the inorganic fillers is formed according to a bond between coupling agents, a liquid crystal silane coupling agent may be used for at least one of the coupling agents. The "liquid crystal silane coupling agent" refers to a silane coupling agent represented by the following Formula (1) having a mesogenic site in a framework of a silane coupling agent. The mesogenic site has liquid crystallinity. In addition, the liquid crystal silane coupling agent contains a silicon compound including a polymerizable compound and an alkoxy group in its structure.

(R₁-O-)ⱼR₅₍₃₋ⱼ₎Si-R^{c}-Z⁴-(A¹-Z⁴)ₘ-R^{a1} (1)

When Compound (1) is mixed with other liquid crystalline compounds, polymerizable compounds, or the like, the mixture is likely to be uniform.

### • Terminal group R^{a1}

The terminal group R^{a1} is preferably a polymerizable group not containing a -C=C- or -C≡C- moiety. For example, polymerizable groups represented by the following Formulae (2-1) and (2-2), cyclohexene oxide, phthalic anhydride, and succinic anhydride can be exemplified, but the present invention is not limited thereto. 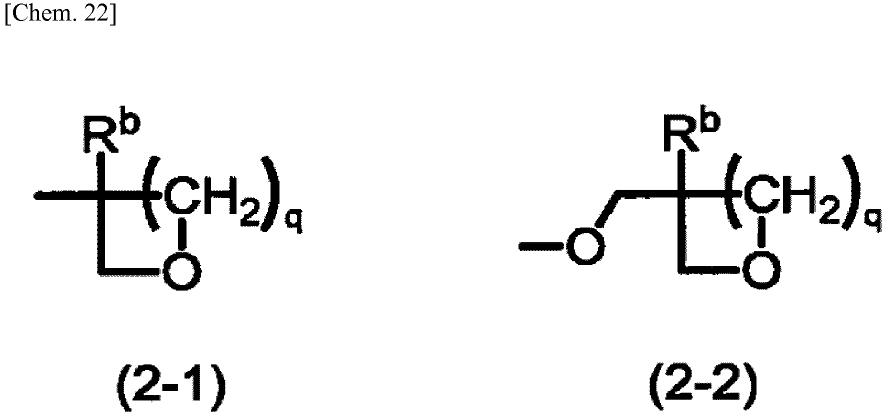 [in Formulae (2-1) and (2-2), R^{b} is a hydrogen atom, a halogen atom, -CF₃, or an alkyl group having 1 to 5 carbon atoms, and q is 0 or 1]

The terminal group R^{a1} may be a group including a functional group that can be bonded to a functional group of an organic compound which is a binding partner. Examples of a combination of functional groups that can be bonded to each other include a combination of an oxiranyl group and an amino group, a combination of methacryloxy groups, a combination of a carboxy or carboxylic acid anhydride residue and an amine, and a combination of imidazole and an oxiranyl group, but the present invention is not limited thereto. A combination with high heat resistance is more preferable.

### • Ring structure A¹

Examples of a preferable A¹ include 1,4-cyclohexylene, 1,4-cyclohexenylene, 2,2-difluoro-1,4-cyclohexylene, 1,3-dioxane-2,5-diyl, 1,4-phenylene, 2-fluoro-1,4-phenylene, 2,3-difluoro-1,4-phenylene, 2,5-difluoro-1,4-phenylene, 2,6-difluoro-1,4-phenylene, 2,3,5-trifluoro-1,4-phenylene, pyridine-2,5-diyl, 3-fluoropyridine-2,5-diyl, pyrimidine-2,5-diyl, pyridazine-3,6-diyl, naphthalene-2,6-diyl, tetrahydronaphthalene-2,6-diyl, fluorene-2,7-diyl, 9-methyl fluorene-2,7-diyl, 9,9-dimethyl fluorene-2,7-diyl, 9-ethyl fluorene-2,7-diyl, 9-fluoro fluorene-2,7-diyl, 9,9-difluoro fluorene-2,7-diyl, and divalent groups represented by the following Formulae (3-1) to (3-7). Here, in Formulae (3-1) to (3-7), * indicates an asymmetric carbon atom.

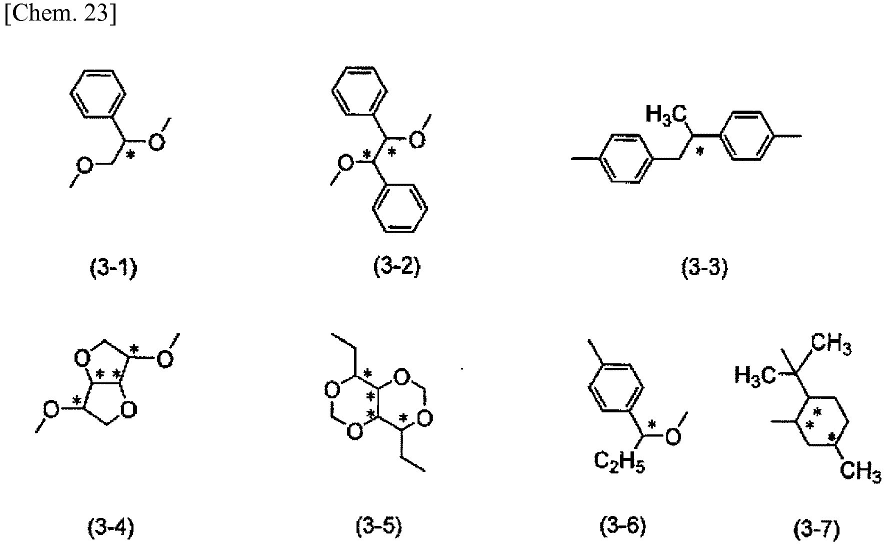

Regarding the configuration of 1,4-cyclohexylene and 1,3-dioxane-2,5-diyl, a trans configuration is preferable to a cis configuration. Since 2-fluoro-1,4-phenylene and 3-fluoro-1,4-phenylene are structurally the same, the latter is not shown. This rule also applies to a relationship between 2,5-difluoro-1,4-phenylene and 3,6-difluoro-1,4-phenylene.

Examples of a more preferable A¹ include 1,4-cyclohexylene, 1,4-cyclohexenylene, 1,3-dioxane-2,5-diyl, 1,4-phenylene, 2-fluoro-1,4-phenylene, 2,3-difluoro-1,4-phenylene, 2,5-difluoro-1,4-phenylene, and 2,6-difluoro-1,4-phenylene. Examples of a particularly preferable A include 1,4-cyclohexylene and 1,4-phenylene.

### • Bond group Z⁴

When the bond group Z⁴ of Compound (1) is a single bond, -(CH₂)₂-, -CH₂O-, -OCH₂-, -CF₂O-, -OCF₂-, or -(CH₂)₄-, and particularly, is a single bond, -(CH₂)₂-, -CF₂O-, -OCF₂-, or -(CH₂)₄-, the viscosity decreases. In addition, when the bond group Z⁴ is -CH=N-, -N=CH-, or -N=N-, a temperature range of a liquid crystal phase is wide. In addition, when the bond group Z is an alkyl group having about 4 to 10 carbon atoms, a melting point is lowered.

Examples of a preferable Z⁴ include a single bond, -(CH₂)₂-, -(CF₂)₂-, -COO-, -OCO-, -CH₂O-,-OCH₂-, -CF₂O-, -OCF₂-, -(CH₂)₄-, -(CH₂)₃O-, -O(CH₂)₃-, -(CH₂)₂COO-, -OCO(CH₂)₂-, -CONR₆-, and -NR₆CO- (R₆ is a hydrogen atom or an alkyl group having 1 to 6 carbon atoms).

Examples of a more preferable Z⁴ include a single bond, -(CH₂)₂-, -COO-, -OCO-, -CH₂O-,-OCH₂-, -CF₂O-, and -OCF₂-. Examples of a particularly preferable Z include a single bond, -(CH₂)₂-, -COO- and -OCO-.

Compound (1), may be optically active or optically inactive. When Compound (1) is optically active, Compound (1) may have an asymmetric carbon atom or may have axial asymmetry. The configuration of an asymmetric carbon atom may be R or S. The asymmetric carbon atom may be positioned in either R^{a1} or A¹. When an asymmetric carbon atom is included, the compatibility of Compound (1) is favorable. When Compound (1) has axial asymmetry, a twisting induction force is large. In addition, light fixation is inconsequential in any case.

As described above, when types of the terminal group R^{a1}, the ring structure A¹ and the bond group Z, and the number of rings are appropriately selected, it is possible to obtain a compound having desired physical properties.

Here, in Compound (1), m is an integer of 1 to 6.

### • Bond group R^{c}

In Compound (1), the bond group R^{c} is an alkylene group having 2 to 3 carbon atoms, and in the alkylene group, any -CH₂- except for -C-C- adjacent to Si is optionally substituted with -CO- or -COO-, -C-C- adjacent to Si is optionally substituted with -C-CR^{d}- and R^{d} is a halogen (Ha) or CHa₃.

Examples of a preferable R^{c} include -C-C-, -C-C-C-, -C-C-CO-, -C-C-CO-O-, -C-CF-CO-O-, and -C-CCF₃-CO-O-. A particularly preferable R^{c} is -C-C-.

### •(R₁-O-)ⱼR₅₍₃₋ⱼ₎Si-

In (R₁-O-)ⱼR₅₍₃₋ⱼ₎Si- of Compound (1), R₁ is a hydrogen atom or an alkyl group having 1 to 5 carbon atoms. Examples of a preferable R₁ include a methyl group and an ethyl group. R₅ is a hydrogen atom or a linear or branched alkyl group having 1 to 8 carbon atoms. Examples of a preferable R₅ include a methyl group. j is an integer of 1 to 3. A preferable j is 3.

### • Method of producing a liquid crystal silane coupling agent

### (1) Obtaining a polymerizable compound

A polymerizable compound is obtained. Preferably, the polymerizable compound has a functional group at both ends. The bifunctional or higher polymerizable compound represented by the above Formula (1-1) may be used. It is preferable that a functional group be provided at both ends on the long side of the polymerizable compound because it is then possible to form a linear bond (crosslinking) using a coupling agent.

The polymerizable compound may be a bifunctional or higher polymerizable liquid crystal compound. For example, the following Formula (4-1) having a vinyl group at both ends can be exemplified.

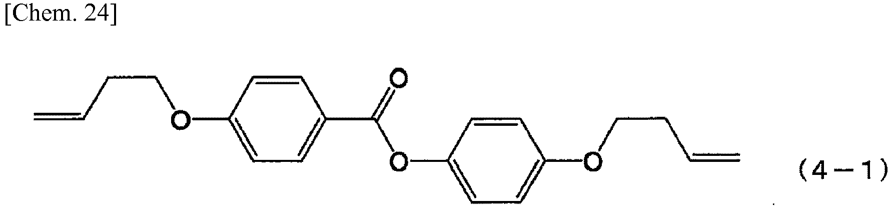

The polymerizable compound may be synthesized or a commercially available product may be purchased.

The polymerizable compound can be synthesized by combining methods known in the field of organic synthetic chemistry. A method of introducing a desired terminal group, ring structure and bond group into a starting material is described in books such as, for example, Houben-Wyle (Methods of Organic Chemistry, Georg Thieme Verlag, Stuttgart), Organic Syntheses (John Wily & Sons, Inc.), Organic Reactions (John Wily & Sons Inc.), Comprehensive Organic Synthesis (Pergamon Press), and New Experimental Chemistry Course (Maruzen). In addition, Japanese Patent No. 5084148 may be referred to.

### (2) Introducing a polymerizable group into any one end of the polymerizable compound

For example, a case in which an epoxy group is introduced as a polymerizable group will be described. In a reaction in which an epoxy group is introduced (epoxidized) into both ends of the above Formula (4-1), and the following Formula (4-4) is generated, when the reaction is stopped midway, the following Formulae (4-2) and (4-3) having an epoxy group at any one end can be obtained as an intermediate product. The generated following Formulae (4-2) and (4-3) can be obtained by dissolving in a solvent, performing separation using a separator, and then removing the solvent.

In this manner, a desired polymerizable group is introduced into any one end by removing the intermediate product.

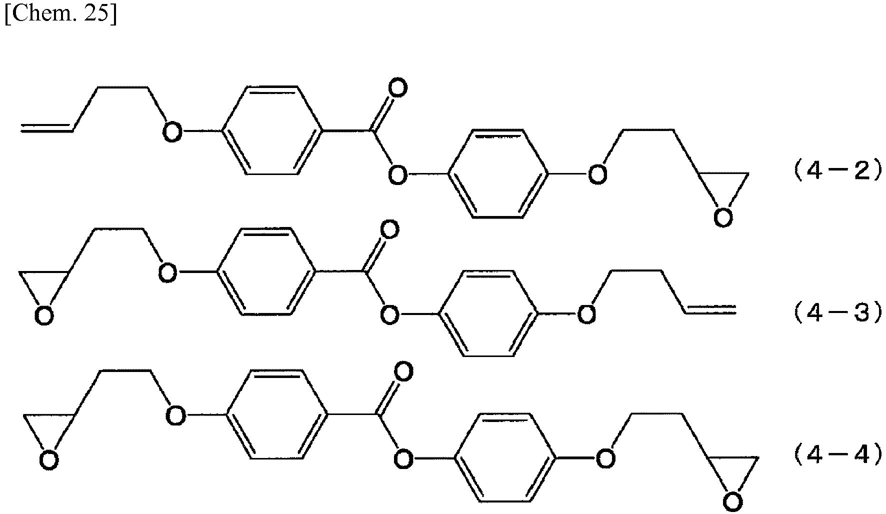

A solvent that removes the intermediate product may be any solvent in which the generated intermediate organism can be dissolved. Examples of the solvent include ethyl acetate, benzene, toluene, xylene, mesitylene, hexane, heptane, octane, nonane, decane, tetrahydrofuran, γ-butyrolactone, N-methyl pyrrolidone, dimethylformamide, dimethylsulfoxide, cyclohexane, methylcyclohexane, cyclopentanone, cyclohexanone, and PGMEA. The above solvents may be used alone, or two or more types thereof may be used in combination.

Here, there is little point in limiting a proportion of the solvent used. In consideration of solubility, solvent cost, energy cost, and the like, the proportion may be determined for each case.

### (3) Introducing Si into an unreacted end of the polymerizable compound

A silicon compound having an alkoxy group may be bonded to an unreacted end of the polymerizable compound.

For example, a trimethoxysilyl group may be introduced into an unreacted functional group (vinyl) side of the above Formulae (4-2) and (4-3). The following Formulae (5-1) and (5-2) may be referred to. Here, introduction of Si may be introduction of a triethoxysilyl group. However, regarding methoxysilane and ethoxysilane, methoxysilane that is highly reactive is preferable.

In addition, some methoxy or ethoxy groups may be substituted with a linear or branched alkyl group having 1 to 8 carbon atoms. For example, methyl, ethyl, n-propyl, i-propyl, n-butyl, s-butyl, t-butyl, and n-octyl groups may be exemplified.

It is not necessary to exhibit liquid crystallinity after Si is introduced. When a polymerizable organic moiety has a liquid crystal structure, after a Si moiety is bonded to an inorganic filler, it is possible to impart high thermal conductivity of a liquid crystalline compound and an effect of improving affinity with other polymerizable compounds to a surface of the inorganic filler.

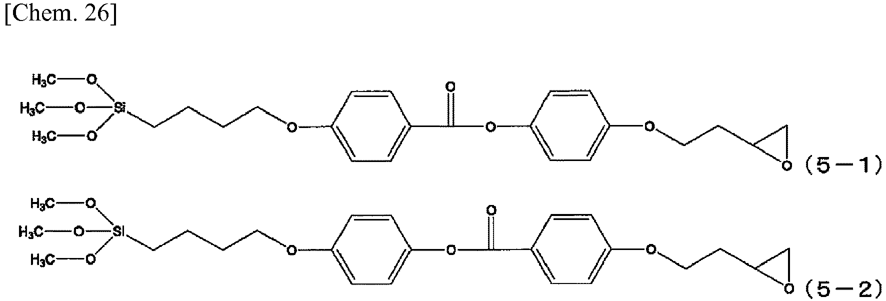

In the method of producing a liquid crystal silane coupling agent, as an example, in a polymerizable compound having a vinyl group at both ends, first, a vinyl group at one end is epoxidized, and next, Si is introduced into the other unreacted vinyl group for production. However, the production method is not limited thereto. Both ends of the polymerizable compound are not limited to a vinyl group as long as a polymerizable group and Si can be introduced.

In addition, while Si may be introduced into the above long chain compound using a hydrosilylation reaction, a liquid crystal silane coupling agent may be synthesized such that the left half and the right half of a long chain compound are first separately synthesized, Si is introduced into the left half using a hydrosilylation reaction, a polymerizable group is introduced into the right half, and the left half and the right half are then connected to each other.

As above, when the coupling agent and the polymerizable compound are appropriately selected, it is possible to connect the first inorganic filler and the second inorganic filler. It is possible to obtain a low thermal expansion member having very high thermal conductivity and controllability of a thermal expansion coefficient from the composition for a low thermal expansion member of the present invention. Here, the above functional groups are only examples, and the present invention is not limited to the above functional groups as long as effects of the present invention can be obtained.

### [Low thermal expansion member]

A low thermal expansion member according to a second embodiment of the present invention is obtained by molding a cured product by curing the composition for a low thermal expansion member according to the first embodiment according to applications. The cured product has high thermal conductivity and has a negative thermal expansion coefficient or a very small positive thermal expansion coefficient, and has excellent chemical stability, heat resistance, hardness and mechanical strength. Here, the mechanical strength refers to a Young's modulus, tensile strength, tear strength, bending strength, flexural modulus of elasticity, impact strength, or the like.

The low thermal expansion member of the present invention is suitable for an interior substrate for a semiconductor module, components of a precision optical device such as an exposure machine, a precision processing device, and the like.

Regarding conditions in which a composition for a low thermal expansion member is cured according to thermal polymerization, a thermosetting temperature is in a range of room temperature to 350 °C, preferably in a range of 50 °C to 250 °C, and more preferably in a range of 50 °C to 200 °C, and a curing time is in a range of 5 seconds to 10 hours, preferably in a range of 1 minute to 5 hours, and more preferably in a range of 5 minutes to 1 hour. After polymerization, preferably, gradual cooling is performed in order to reduce stress strain and the like. In addition, a reheating treatment may be performed to alleviate distortion, irregularities, and the like.

The low thermal expansion member is formed from the composition for a low thermal expansion member and used in the form of a sheet, a film, a thin film, a fiber, a molded article, or the like. A preferable form is a form of a plate, a sheet, a film or a thin film. Here, in this specification, a film thickness of a sheet is 1 mm or more, a film thickness of a film is 5 µm or more, preferably 10 to 500 µm, and more preferably 20 to 300 µm, and a film thickness of a thin film is less than 5 µm. The film thickness may be appropriately changed according to applications. The composition for a low thermal expansion member can be directly used as a low thermal expansion adhesive or a low thermal expansion filler.

### [Electronic instrument]

An electronic instrument according to a third embodiment of the present invention includes the low thermal expansion member according to the second embodiment and an electronic device including a heating unit or a cooling unit. The low thermal expansion member is disposed on the electronic device such that it comes in contact with the heating unit. The form of the low thermal expansion member may be any of a low thermal expansion electronic substrate, a low thermal expansion plate, a low thermal expansion sheet, a low thermal expansion film, a low thermal expansion adhesive, and a low thermal expansion molded article.

Examples of the electronic device include a semiconductor module. The low thermal expansion member has high thermal conductivity, high heat resistance, and strong insulation properties in addition to low thermal expansion properties. Therefore, it is particularly effective for an insulated gate bipolar transistor (IGBT) which requires a more efficient heat dissipation mechanism for high power among semiconductor devices. An IGBT is one of semiconductor devices and is a bipolar transistor in which an MOSFET is incorporated in a gate part, and is used for power control. Examples of the electronic instrument including an IGBT include a main conversion element of a high power inverter, an uninterruptible power system, a variable voltage variable frequency control device of an AC motor, a control device of a railway vehicle, a hybrid vehicle, an electric transport device such as an electric vehicle, and an IH cooking device.

In the present invention, while a case in which a second inorganic filler subjected to a coupling treatment and a first inorganic filler that is subjected to a coupling treatment and then additionally modified with a polymerizable compound are bonded to each other, a bond between the inorganic fillers is formed, and a low thermal expansion member having low thermal expansion properties and high thermal conductivity is obtained has been described above, the present invention is not limited thereto. Of course, a second inorganic filler that is subjected to a coupling treatment and then additionally modified with a polymerizable compound and a first inorganic filler subjected to a coupling treatment are bonded to each other and thus a bond between the inorganic fillers may be formed.

In addition, using only an inorganic filler that is subjected to a coupling treatment and then additionally modified with a polymerizable compound, polymerizable compounds are bonded to each other according to an appropriate polymerization initiator or the like, and a bond between the inorganic fillers may be formed.

That is, in the present invention, in combining an inorganic material and an organic compound, a bond is formed between inorganic materials according to the organic compound, thermal conductivity is significantly improved, and additionally, a thermal expansion coefficient is controlled.

### Examples

The present invention will be described below in detail with reference to examples. However, the present invention is not limited to the details described in the following examples.

Component materials constituting a low thermal expansion member used for examples of the present invention are as follows.

### <Polymerizable liquid crystal compound>

- Liquid crystal epoxy compound: Compound (commercially available from JNC) represented by the following Formula (6-1)

The compound can be synthesized by a method described in Japanese Patent No. 5084148.

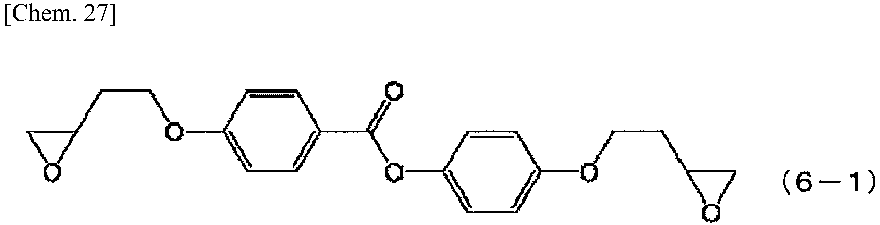

### <Polymerizable compound>

- Epoxy compound: Compound (jER828 (product name) commercially available from Mitsubishi Chemical Corporation) represented by the following Formula (7-1) 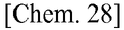 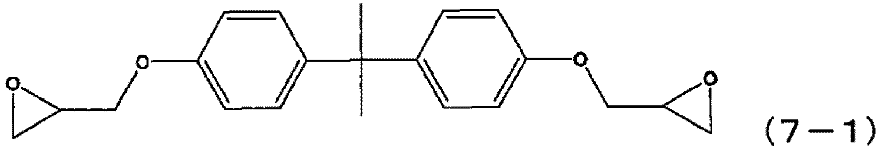
- 1,4-Butanediol diglycidyl ether (commercially available from Tokyo Chemical Industry)

### <Inorganic filler>

- Spherical alumina: TS-6(LV) commercially available from Tatsumori Ltd.
- Plate-like alumina: Serath YFA02025 commercially available from Kinsei Matec Co., Ltd.

### <Silane coupling agent>

- N-(2-aminoethyl)-3-aminopropyltrimethoxysilane (S320 (product name) commercially available from JNC) represented by the following Formula (8-1) 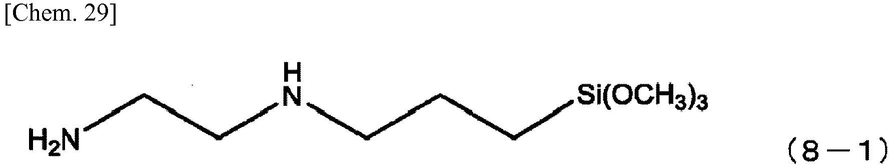
- 3-aminopropyltrimethoxysilane (KBM-903 (product name) commercially available from Shin-Etsu Chemical Co., Ltd.) represented by the following Formula (8-2)

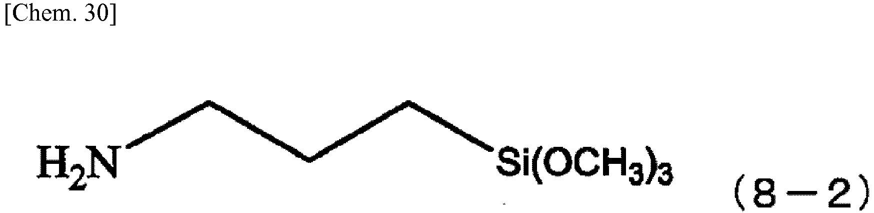

### [Example 1]

### <Preparation of low thermal expansion member >

A preparation example of a low thermal expansion member will be described below.

### • Preparation boron nitride particles treated with a coupling agent

5.00 g of spherical alumina and 0.75 g of N-(2-aminoethyl)-3-aminopropyltrimethoxysilane were added to 50 mL of toluene (anhydrous), and the mixture was stirred at 750 rpm for 1 hour using a stirrer. The obtained mixture was dried at 40 °C for 5 hours, and at room temperature for 19 hours. In addition, after the solvent was dried, a heat treatment was performed using a vacuum dryer set at 125 °C under vacuum conditions for 5 hours.

Spherical alumina modified with the coupling agent was transferred into a sample tube, 50 mL of THF (commercially available from Nacalai Tesque Inc.) was added thereto, and pulverization was then performed using an ultrasonic treatment device (MODEL450 commercially available from BRANSON). In addition, this solution was separated off and purified using a centrifuge (CT6E commercially available from Hitachi Koki Co., Ltd.) at 6,000 rpm for 10 minutes. After the supernatant solution was discarded, 50 mL of acetone was added thereto, and the same operation was performed twice. The modified spherical alumina after purification was dried in an oven at 60 °C for 24 hours. The obtained particles were used as a second inorganic filler B modified with a second coupling agent.

2.00 g and 4.00 g of the above B and the liquid crystal epoxy compound (6-1) were weighed out (content of spherical alumina was 13 volume%), respectively, on pharmaceutical paper, and mixed using a mortar, and kneading was then performed using two rollers (HR-3 commercially available from Nitto reactor) at 120 °C for 10 minutes. Then, separation and purification were performed through an ultrasonic treatment and centrifugation, and spherical alumina particles modified with the liquid crystal epoxy compound from which unreacted components were removed was obtained. The particles were used as a first inorganic filler A modified with the first coupling agent and the polymerizable liquid crystal compound.

A coating amount of the above A and the above B with respect to BN particles of a silane coupling agent or a liquid crystal epoxy compound was calculated from a heating loss at 600 °C using a TG-DTA device (EXSTAR TG/DTA5200 commercially available from Seiko Instruments Inc. (currently Hitachi High-Technologies Corporation)).

### • Mixing the above A and the above B

0.954 g of the prepared first inorganic filler A and 0.373 g of the prepared second inorganic filler B were weighted out and mixed using an agate mortar. Then, the mixture was mixed using two rollers at 55 °C for 10 minutes and a desired composition for a low thermal expansion member of the present invention was obtained. The weight ratio was calculated assuming that the numbers of NH groups (since the reactive group of S320 has one NH₂ and one NH, the number of NH groups is 3) of the first inorganic filler A and epoxy rings of the second inorganic filler B were 1:1.

### • Polymerization and molding

The obtained mixture was inserted between stainless steel plates, pressing was performed to 9.8 MPa using a compression molding machine (F-37 commercially available from Shinto Metal Industry Corporation) set at 150 °C, a heated state continued for 15 minutes, and thus an alignment treatment and pre-curing were performed. That is, when a mixture was spread between the stainless steel plates, the particles and the stainless steel plates were aligned to be parallel to each other. In addition, an amount of the sample was adjusted such that the thickness of the sample was about 200 µm. In addition, post-curing was performed at 80 °C for 1 hour and at 150 °C for 3 hours using an oven, and a desired low thermal expansion member of the present invention was obtained. Here, in this state, a total amount of the silane coupling agent and the polymerizable liquid crystal compound was about 15 volume%.

### • Evaluation of thermal conductivity and thermal diffusivity

Regarding the thermal conductivity, a specific heat (measured by a DSC type input compensation type differential scanning calorimeter EXSTAR 6000 commercially available from Seiko Instruments Inc. (currently Hitachi High-Technologies Corporation.)) and a specific gravity (measured by a specific gravity meter AG204 density measurement kit commercially available from METTLER TOLEDO) of the low thermal expansion member were obtained in advance, the value was multiplied by a thermal diffusivity obtained by a TC7000 thermal diffusivity measurement device (commercially available from Advance Riko, Inc), and thereby the thermal conductivity was obtained. Here, the thermal diffusivity in the thickness direction was measured when a sample was subjected to a blackening treatment using a carbon spray, and standard sample holder was used. In addition, an adapter with a distance of 5 mm between a location at which a laser beam was emitted and a location at which infrared rays were detected was produced, and the thermal diffusivity in the planar direction was calculated from a time until infrared rays were emitted from when a laser beam was emitted to the sample, and a distance thereof.

### • Evaluation of thermal expansion coefficient

A 5×20 mm test piece was cut out from the obtained sample, and a thermal expansion coefficient (measured by a TMA 7000 type thermomechanical analyzer commercially available from (currently) Hitachi High-Technologies Corporation) was obtained in a range of room temperature to 250 °C. A temperature range was appropriately adjusted according to a heat resistance of the sample to be measured.

### [Example 2]

A sample was prepared in the same conditions as in Example 1 except that plate-like alumina was used in place of spherical alumina in Example 1 and evaluated. The results are shown in Example 2.

### [Comparative Example 1]

The same spherical alumina and epoxy compound as used in Example 3 and an amine curing agent (4,4'-diamino-1,2-diphenylethane (commercially available from JNC)) as a curing agent were weighed out on pharmaceutical paper such that a resin component (liquid crystalline epoxy component+diamine component) was 15 volume% and mixed using a mortar, and kneading was then performed using two rollers (HR-3 commercially available from Nitto reactor) at 120 °C for 10 minutes. That is, in Examples 1 to 3, alumina particles were directly bonded to each other using a silane coupling agent and an epoxy resin. However, like an alumina/epoxy composite resin wised used, Comparative Example 1 had a structure in which epoxy resins were bonded to each other by an amine curing agent and alumina fillers were dispersed in each bonded epoxy resin. The thermal conductivity and thermal expansion coefficient of the obtained sample were measured in the same manner as in Example 1. The result was used as Comparative Example 1.

The results obtained by measuring the thermal conductivity of Examples 1 and 2 and Comparative Example 1 are shown in Table 1.

### [Table 1]

**Table 1: Thermal conductivity of composite alumina material**

| | Actual composition (weight proportion of alumina:polymerizable compound) | Thermal conductivity in x-y direction (W/mK) | Thermal conductivity in thickness direction (W/mK) |
|---|---|---|---|
| Example 1 | 81.7 | 3.88 | 3.85 |
| Example 2 | 76.5 | 3.0 | 0.62 |
| Comparative Example 1 | 80.0 | 6.6 | 6.7 |

The results obtained by measuring the thermal expansion coefficient of Examples 1 and 2 and Comparative Example 1 are shown in Table 2.

### [Table 2]

**Table 2: Thermal expansion coefficient of composite alumina material**

| | Thermal expansion coefficient (×10⁻⁶K⁻¹) | | | | | |
|---|---|---|---|---|---|---|
| | 100 to 120 °C | 120 to 140 °C | 140 to 160 °C | 160 to 180 °C | 180 to 200 °C | Average |
| Example 1 (spherical alumina 81.4 vol%) | 20.65 | 20.87 | 21.05 | 21.44 | 20.6 | 20.92 |
| Example 2 (plate-like alumina 74.1 vol%) | 5.622 | 6.404 | 7.064 | 7.141 | 5.827 | 6.410 |
| Comparative Example 1 | 13.67 | 24.1 | 37.03 | 38.67 | Destructed | 24.94 |

According to the results of Examples 1 and 2, the low thermal expansion member of the present invention had more favorable heat resistance and had a thermal expansion coefficient that can be controlled at a higher temperature than a member prepared by dispersing an inorganic filler in a resin of the related art. In addition, the thermal expansion coefficient of Example 1 was very close to a thermal expansion coefficient of a copper wiring used in the semiconductor device and a problem of peeling off of the substrate and the copper wiring due to a difference between thermal expansion coefficients was unlikely to occur. In addition, when the thermal expansion coefficient was measured in Example 1 and Example 2, the thermal expansion coefficient was almost constant, and no change in the thermal expansion coefficient due to a glass transition point was observed. On the other hand, in Comparative Example 1, the slope of the thermal expansion coefficient was largely changed from 120 °C to 150 °C. This is because a glass transition occurred at this temperature. In general, a heat resistant resin is preferably used at a glass transition temperature or lower. Therefore, it can be understood that the composition for a low thermal expansion member of the present invention is a composition that can form a member suitable for a semiconductor device and a precision instrument in which thermal distortion is a problem.

All references including publications, patent applications, and patents cited in this specification are referred to and incorporated herein to the same extent as if the references were individually exemplified, referred to and incorporated, and all details thereof are described herein.

The use of nouns and corresponding demonstratives in the context of describing the present invention (especially in the context of the following claims) is to be construed to cover both the singular and the plural unless otherwise specified herein or otherwise clearly contradicted by context. The terms "comprise," "include," "contain," and "have" are interpreted as open-ended terms (that is, to mean "includes, but is not limited to") unless otherwise noted. Unless otherwise specified in this specification, the numerical ranges of objects in this specification are merely intended to serve as abbreviations for individually indicating values falling within the ranges, and the values are incorporated in this specification as if they were individually recited herein. All methods described herein can be performed in any appropriate order unless otherwise described herein or otherwise clearly contradicted by context. Unless otherwise claimed, any example or exemplary phrase (for example, "such as") used herein is intended merely to better describe the present invention and is not intended to limit the scope of the present invention. Terms in this specification should not be construed to indicate elements that are essential for the implementation of the present invention but are not described in the claims.

This specification includes the best means for implementing the present invention known to the inventors and preferable embodiments of the present invention have been described. Those skilled in the art will clearly understand modifications of such preferable embodiments that may be made upon reading the above description. The inventors expect such skilled people to appropriately apply such modifications and assume that the present invention will be implemented using methods other than those specifically described herein. Accordingly, the present invention includes all modifications and equivalents of content described in the claims appended to this specification as allowed by applicable law. Moreover, the present invention encompasses any combination of the above elements in all of the modifications unless otherwise described herein or clearly contradicted by the context.

### [Reference Signs List]

1 First inorganic filler
2 Second inorganic filler
11 First silane coupling agent
12 Second silane coupling agent
13 First silane coupling agent, liquid crystal silane coupling agent
21 Polymerizable compound, polymerizable liquid crystal compound

## Claims

1. A composition for a low thermal expansion member comprising:
a thermally conductive first inorganic filler that is bonded to one end of a first coupling agent; and
a thermally conductive second inorganic filler that is bonded to one end of a second coupling agent,
wherein the first inorganic filler and the second inorganic filler are bonded to each other via the first coupling agent and the second coupling agent through curing treatment.

2. The composition for a low thermal expansion member according to claim 1,
wherein the first inorganic filler and the second inorganic filler are at least one selected from the group consisting of alumina, magnesium oxide, zinc oxide, silica, cordierite, silicon nitride, and silicon carbide.

3. The composition for a low thermal expansion member according to claim 1 or 2,
wherein the first coupling agent and the second coupling agent are the same.

4. The composition for a low thermal expansion member according to any one of claims 1 to 3, further comprising
a thermally conductive third inorganic filler having a different thermal expansion coefficient from those of the first inorganic filler and the second inorganic filler.

5. The composition for a low thermal expansion member according to any one of claims 1 to 4, further comprising
an organic compound, a polymer compound, or glass fibers that are not bonded to the first inorganic filler or the second inorganic filler.

6. The composition for a low thermal expansion member according to any one of claims 1 to 5,
wherein one end of a bifunctional or higher polymerizable compound is bonded to the other end of the first coupling agent, and
wherein the other end of the polymerizable compound is bonded to the other end of the second coupling agent through curing treatment.

7. The composition for a low thermal expansion member according to claim 6,
wherein the bifunctional or higher polymerizable compound is at least one polymerizable liquid crystal compound represented by the following Formula (1-1):
Rₐ-Z-(A-Z)ₘ-R^{a} (1-1)
in the above Formula (1-1),
R^{a} independently represents a functional group that can be bonded to a functional group of the other end of a first coupling agent and a second coupling agent;
A is 1,4-cyclohexylene, 1,4-cyclohexenylene, 1,4-phenylene, naphthalene-2,6-diyl, tetrahydronaphthalene-2,6-diyl, fluorene-2,7-diyl, bicyclo[2.2.2]oct-1,4-diyl, or bicyclo[3.1.0]hex-3,6-diyl,
in these rings, any -CH₂- is optionally substituted with -O-, any -CH= is optionally substituted with -N=, and any hydrogen atom is optionally substituted with a halogen atom, an alkyl group having 1 to 10 carbon atoms, or an alkyl halide having 1 to 10 carbon atoms,
in the alkyl group, any -CH₂- is optionally substituted with -O-, -CO-, -COO-, -OCO-, -CH=CH-, or -C≡C-;
Z independently represents a single bond or an alkylene group having 1 to 20 carbon atoms,
in the alkylene group, any -CH₂- is optionally substituted with -O-, -S-, -CO-, -COO-, -OCO-, -CH=CH-, -CF=CF-, -CH=N-, -N=CH-, -N=N-, -N(O)=N-, or -C≡C-, and any hydrogen atom is optionally substituted with a halogen atom;
m is an integer of 1 to 6.

8. The composition for a low thermal expansion member according to claim 7,
wherein, in Formula (1-1), A is 1,4-cyclohexylene, 1,4-cyclohexylene in which any hydrogen atom is substituted with a halogen atom, 1,4-phenylene, 1,4-phenylene in which any hydrogen atom is substituted with a halogen atom or a methyl group, fluorene-2,7-diyl, or fluorene-2,7-diyl in which any hydrogen atom is substituted with a halogen atom or a methyl group.

9. The composition for a low thermal expansion member according to claim 7 or 8,
wherein, in Formula (1-1), Z is a single bond, -(CH₂)ₐ-, -O(CH₂)ₐ-, -(CH₂)ₐO-, -O(CH₂)ₐO-, -CH=CH-, -C≡C-, -COO-, -OCO-, -CH=CH-COO-, -OCO-CH=CH-, -CH₂CH₂-COO-, -OCO-CH₂CH₂-, -CH=N-, -N=CH-, -N=N-, -OCF₂- or -CF₂O-, and a is an integer of 1 to 20.

10. The composition for a low thermal expansion member according to any one of claims 7 to 9,
wherein, in Formula (1-1), R^{a} each represents polymerizable groups having the following Formulae (2-1) and (2-2), cyclohexene oxide, phthalic anhydride, or succinic anhydride, 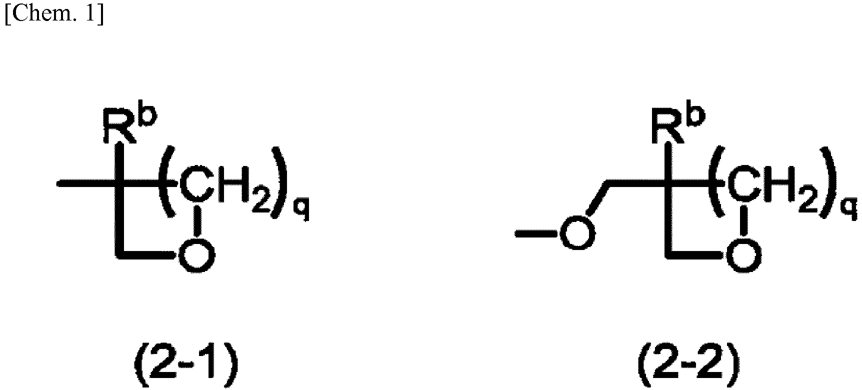 in Formulae (2-1) and (2-2), R^{b} is a hydrogen atom, a halogen atom, -CF₃, or an alkyl group having 1 to 5 carbon atoms, and q is 0 or 1.

11. The composition for a low thermal expansion member according to any one of claims 1 to 5,
wherein the first coupling agent and the second coupling agent each have a functional group that can be bonded to each other at the other ends thereof, and
wherein the other end of the first coupling agent is bonded to the other end of the second coupling agent through curing treatment.

12. The composition for a low thermal expansion member according to any one of claims 1 to 11,
wherein the first inorganic filler and the second inorganic filler have a spherical shape.

13. A low thermal expansion member obtained by curing the composition for a low thermal expansion member according to any one of claims 1 to 12.

14. An electronic instrument comprising:
the low thermal expansion member according to claim 13; and
an electronic device including a heating unit,
wherein the low thermal expansion member is disposed on the electronic device such that it comes in contact with the heating unit.

15. A method of producing a low thermal expansion member comprising:
a process of bonding a thermally conductive first inorganic filler to one end of a first coupling agent;
a process of bonding a thermally conductive second inorganic filler to one end of a second coupling agent; and
a process of bonding the other end of the first coupling agent to one end of a bifunctional or higher polymerizable compound and bonding the other end of the polymerizable compound to the other end of the second coupling agent or a process of bonding the other end of the first coupling agent to the other end of the second coupling agent.
